# EUROPEAN PATENT APPLICATION

(11) **EP 4 579 407 A1**
(43) Date of publication of application: **02.07.2025**
(21) Application number: 24223455.7
(22) Date of filing: 27.12.2024
(51) Int. Cl.: G06F 3/041, G06F 3/044, H10K 59/40

(54) **DISPLAY DEVICE**

(30) Priority: 28.12.2023 KR 20230195534
(71) Applicant: Samsung Display Co., Ltd., Yongin-si, Gyeonggi-do 17113 (KR)
(72) Inventor: BOK, SEUNG-LYONG, 17113 Yongin-si (KR); KIM, KICHEOL, 17113 Yongin-si (KR)
(74) Representative: Walaski, Jan Filip

(57) **Abstract**

A display device includes: a display panel including a display area including a transmission area, and a non-display area adjacent to the display area; and an input sensor on the display panel and including a plurality of conductive patterns, wherein the plurality of conductive patterns includes: a first sensing electrode comprising a plurality of first sensing patterns arranged along a first direction and a plurality of bridge patterns configured to connect adjacent two first sensing patterns of the plurality of first sensing patterns to each other; a second sensing electrode spaced from the first sensing electrode and a plurality of second sensing patterns arranged along a second direction crossing the first direction; and a transparent electrode electrically connected to at least a portion of the first sensing electrode and the second sensing electrode.

## Description

### CROSS-REFERENCE TO RELATED APPLICATIONS

The present application claims priority to Korean Patent Application No. 10-2023-0195534, filed on 28 December 2023.

### BACKGROUND

### 1. Field

The present disclosure relates to a display device, and more specifically, to a display device having improved transmittance and improved sensing sensitivity of an external input.

### 2. Description of the Related Art

Multimedia devices such as televisions, mobile phones, tablets, navigation devices, game consoles, etc. include display devices, each of which displays images to a user through a display screen. Such a display device may include a display panel that generates an image and an input sensor that detects a user's touch.

Recently, due to technological advancements, transparent display devices in which a transmission area within a display area is transparent have been developed. The input sensor may include a conductor that detects an external input, and the conductor of the input sensor disposed on the display panel may affect emission efficiency and/or transmittance of the display device.

### SUMMARY

The present disclosure provides a display device having improved external input sensing sensitivity of an input sensor while improving transmittance of a display area.

One or more embodiments of the present disclosure provide a display device including: a display panel including a display area including a transmission area, and a non-display area adjacent to the display area; and an input sensor on the display panel and including a plurality of conductive patterns, wherein the plurality of conductive patterns includes: a first sensing electrode including a plurality of first sensing patterns arranged along a first direction and a plurality of bridge patterns configured to connect adjacent two first sensing patterns of the plurality of first sensing patterns to each other; a second sensing electrode spaced from the first sensing electrode and a plurality of second sensing patterns arranged along a second direction crossing the first direction; and a transparent electrode electrically connected to at least a portion of the first sensing electrode and the second sensing electrode, wherein each of the plurality of first sensing patterns and the plurality of second sensing patterns includes a plurality of mesh lines in which a transmission opening overlapping the transmission area is located, and wherein the transparent electrode overlaps at least a portion of the transmission area.

In one or more embodiments, the display area further includes a plurality of pixel areas adjacent to the transmission area and configured to emit light.

In one or more embodiments, in the display area, a ratio of the transmission area to an entire area of the transmission area and the plurality of pixel areas is about 60% or more.

In one or more embodiments, the input sensor further includes a cover insulating layer between the first and second sensing electrodes and the transmission electrode, and wherein the transparent electrode is electrically connected to at least a portion of the first sensing electrode and the second sensing electrode through an upper contact hole that passes through the cover insulating layer.

In one or more embodiments, the transparent electrode overlaps at least a portion of each of the transmission area and the plurality of pixel areas.

In one or more embodiments, the plurality of conductive patterns further includes a dummy pattern at a same layer as the transparent electrode and insulated from the first sensing electrode and the second sensing electrode.

In one or more embodiments, the plurality of pixel areas includes a first pixel area, a second pixel area, and a third pixel area, and the transmission area is adjacent to each of the first pixel area, the second pixel area, and the third pixel area along the second direction.

In one or more embodiments, the transparent electrode includes transparent conductive oxide (TCO).

In one or more embodiments, the display panel includes a light emitting element configured to emit source light and overlapping a corresponding one of at least the plurality of pixel areas, and the light emitting element includes: a first electrode; a first light emitting stack on the first electrode; a second light emitting stack on the first light emitting stack; a third light emitting stack on the second light emitting stack; a fourth light emitting stack on the third light emitting stack; a second electrode on the fourth light emitting stack; and charge generation layers between the first, second, third, and fourth light emitting stacks, respectively, wherein each of the first to fourth light emitting stacks includes at least one emission layer.

In one or more embodiments, the display device further includes a light control layer on the light emitting element to transmit the source light or convert the source light into light having a different wavelength.

In one or more embodiments, the light control layer includes: a bank including a plurality of bank openings; and a plurality of light control patterns in the plurality of bank openings, respectively, wherein the plurality of light control patterns do not overlap the transmission area.

In one or more embodiments, the at least one emission layer in each of the first light emitting stack to the fourth light emitting stack does not overlap the transmission area.

In one or more embodiments, the second sensing electrode further includes a connection pattern between adjacent two second sensing patterns of the plurality of second sensing patterns and having a shape integrated with the plurality of second sensing patterns.

In one or more embodiments, the input sensor further includes a sensing insulating layer between the plurality of bridge patterns and the plurality of first sensing patterns, wherein each of the plurality of bridge patterns is electrically connected to corresponding one of the plurality of first sensing patterns through a lower contact hole defined in the sensing insulating layer.

In one or more embodiments, the transmission area includes: a first transmission area overlapping the transparent electrode on a plane; and a second transmission area that does not overlap the transparent electrode on the plane.

In one or more embodiments, a display device including: a display panel including a display area having a transmission area, and a non-display area adjacent to the display area; and an input sensor on the display panel and including a plurality of conductive patterns, wherein the plurality of conductive patterns includes: a plurality of unit sensing patterns arranged along a first direction and a second direction crossing the first direction and insulated from each other; and a plurality of unit signal lines connected to at least some of the plurality of unit sensing patterns, respectively, wherein each of the plurality of unit sensing patterns includes a plurality of mesh lines in which a transmission opening overlapping at least the transmission area is defined, and each of the plurality of unit signal lines includes a plurality of sub signal lines connected to corresponding one unit sensing pattern of the plurality of unit sensing patterns and extending in the first direction.

In one or more embodiments, the plurality of sub signal lines includes: a first sub signal line connected to a first unit sensing pattern that is one of the unit sensing patterns and extending in the first direction; a second sub signal line connected to the first unit sensing pattern, extending in the first direction, and spaced from the first sub signal line in the second direction; and a third sub signal line connected to the first unit sensing pattern, extending in the first direction, and spaced from the first sub signal line and the second sub signal line in the second direction.

In one or more embodiments, each of the plurality of sub signal lines has a width of about 1 micrometer or more and about 5 micrometers or less, and wherein a distance between the plurality of sub signal lines is about 3 micrometers or more and about 7 micrometers or less.

In one or more embodiments, the plurality of conductive patterns further includes an additional signal line having a shape integrated with a portion of the plurality of unit sensing patterns, electrically connected to the portion of the plurality of unit sensing patterns, and overlapping the non-display area.

In one or more embodiments, the input sensor further includes a sensing insulating layer between the plurality of unit sensing patterns and the plurality of unit lines, and wherein each of the plurality of unit signal lines is electrically connected to corresponding one of the plurality of unit sensing patterns through a unit contact hole passing through the sensing insulating layer.

In one or more embodiments, the display area further includes a plurality of pixel areas adjacent to the transmission area and configured to emit light.

In one or more embodiments, in the display area, a ratio of the transmission area to an entire area of the transmission area and the plurality of pixel areas is about 60% or more.

In one or more embodiments, the plurality of pixel areas includes a first pixel area, a second pixel area, and a third pixel area, and wherein the transmission area is adjacent to each of the first pixel area, the second pixel area, and the third pixel area along the second direction.

In one or more embodiments, the display panel includes a light emitting element configured to emit source light and overlapping corresponding one of the at least the plurality of pixel areas, and the light emitting element includes: a first electrode; a first light emitting stack on the first electrode; a second light emitting stack on the first light emitting stack; a third light emitting stack on the second light emitting stack; a fourth light emitting stack on the third light emitting stack; a second electrode on the fourth light emitting stack; and charge generation layers between the first, second, third, and fourth light emitting stacks, respectively, wherein each of the first to fourth light emitting stacks includes at least one emission layer.

In one or more embodiments, the display device further includes a light control layer on the light emitting element to transmit the source light or convert the source light into light having a different wavelength.

In one or more embodiments, the light control layer includes: a bank having a plurality of bank openings; and a plurality of light control patterns in the plurality of bank openings, respectively, wherein the plurality of light control patterns do not overlap the transmission area.

In one or more embodiments, the at least one emission layer in each of the first light emitting stack to the fourth light emitting stack does not overlap the transmission area.

In one or more embodiments, a display device includes: a display panel including a display area having a transmission area and a plurality of pixel areas adjacent to the transmission area, and a non-display area adjacent to the display area; and an input sensor on the display panel and including a plurality of conductive patterns, wherein the plurality of conductive patterns includes a plurality of sensing patterns arranged along a first direction and a second direction crossing the first direction, wherein the sensing patterns include a plurality of mesh lines, wherein a transmission opening overlapping the transmission area and a pixel opening overlapping each of the plurality of pixel areas are in the plurality of mesh lines, and wherein in the display area, a ratio of the transmission area to the total area of the transmission area and the plurality of pixel areas is about 60% or more.

### BRIEF DESCRIPTION

The accompanying drawings are included to provide a further understanding of the present disclosure, and are incorporated in and constitute a part of this specification. The drawings illustrate embodiments of the present disclosure and, together with the description, serve to explain principles and/or scope of the present disclosure. In the drawings:
FIG. 1A is a perspective view of an electronic device;
FIG. 1B is a perspective view of a curved electronic device;
FIG. 2 is a cross-sectional view of a display device;
FIG. 3A is a plan view of the display device;
FIG. 3B is an enlarged plan view illustrating a portion of the display device;
FIG. 4 is an equivalent circuit diagram of a pixel;
FIGS. 5 and 6 are cross-sectional views of the display device;
FIG. 7 is a cross-sectional view of a light emitting element;
FIG. 8 is a plan view of an input sensor;
FIGS. 9A and 9B are enlarged plan views illustrating a portion of an input sensor;
FIGS. 9C and 9D are enlarged cross-sectional views illustrating a portion of the input sensor;
FIGS. 10A - 10C are enlarged plan views illustrating a portion of the display device;
FIG. 11 is a plan view of the input sensor;
FIG. 12A is an enlarged plan view illustrating a portion of the input sensor;
FIG. 12B is an enlarged plan view illustrating some of a configuration of the input sensor;
FIG. 12C is an enlarged cross-sectional view illustrating a portion of the input sensor; and
FIG. 13 is a plan view of the input sensor.

### DETAILED DESCRIPTION

Hereinafter, embodiments of the present disclosure will be described with reference to the accompanying drawings.

In this specification, it will also be understood that when one component (or region, layer, portion, etc.) is referred to as being 'on', 'connected to', or 'coupled to' another component, it can be directly connected/coupled on/to the one component, or an intervening third component may also be present.

Like reference numerals refer to like elements throughout. Also, in the figures, the thickness, ratio, and dimensions of components are exaggerated for clarity of illustration. The term "and/or" includes any and all combinations of one or more of the associated listed items.

It will be understood that although the terms such as 'first' and 'second' are used herein to describe various elements, these elements should not be limited by these terms. These terms are used only to distinguish one component from other components. For example, a first element referred to as a first element in an embodiment can be referred to as a second element in another embodiment without departing from the spirit or scope of the appended claims. The terms of a singular form may include plural defines unless referred to the contrary.

Also, "under", "below", "above', "upper", and the like are used for explaining relation association of components illustrated in the drawings. The terms may be a relative concept and described based on directions expressed in the drawings.

The meaning of "include" or "comprise" specifies a property, a fixed number, a step, an operation, an element, a component or a combination thereof, but does not exclude other properties, fixed numbers, steps, operations, elements, components or combinations thereof.

In this specification, "being directly disposed" may mean that there is no layer, film, area, plate, and/or the like between a portion of the layer, the film, the area, the plate, and/or the like and the other portion. For example, "directly disposed" may mean being disposed without using an additional member such and an adhesion member between two layers or two members.

Unless otherwise defined, all terms (including technical and scientific terms) used herein have the same meaning as commonly understood by a person of ordinary skill in the art to which the present disclosure belongs. In addition, terms such as terms defined in commonly used dictionaries should be interpreted as having a meaning consistent with the meaning in the context of the related technology, and unless explicitly defined here, they are interpreted as too ideal or too formal sense.

In the specification and the claims, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or." In the specification and the claims, the phrase "at least one of" is intended to include the meaning of "at least one selected from the group of" for the purpose of its meaning and interpretation. For example, "at least one of A and B" may be understood to mean "A, B, or A and B."

A person of ordinary skill in the art would appreciate, in view of the present disclosure in its entirety, that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

Hereinafter, a display device will be described with reference to the accompanying drawings.

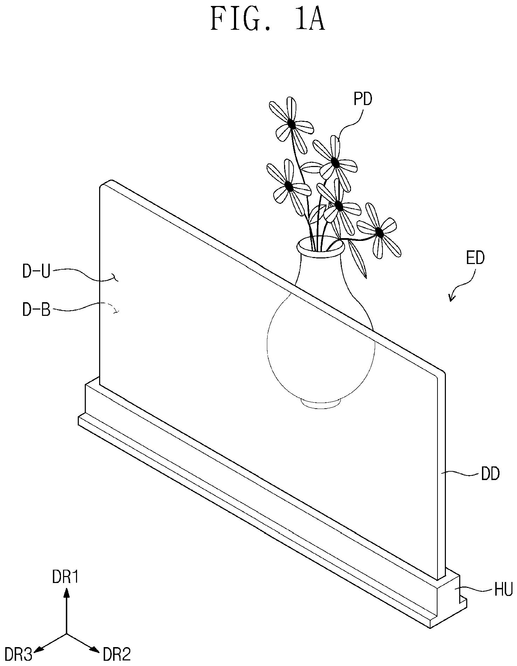

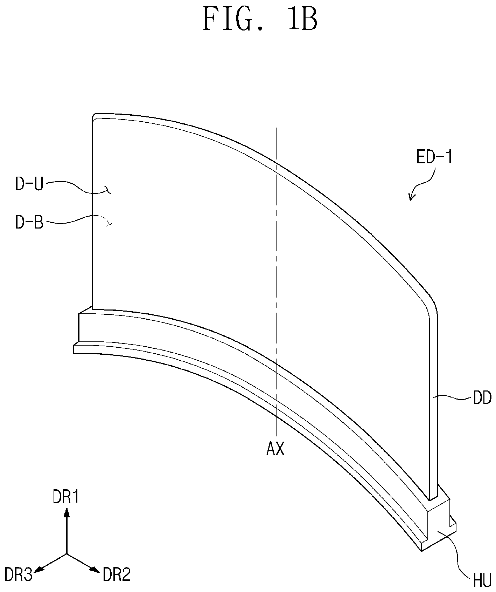

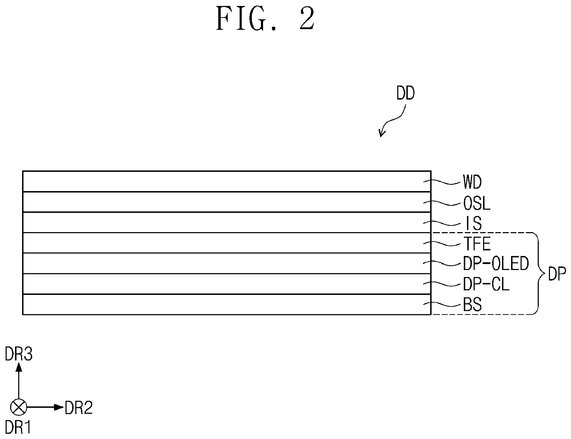

FIG. 1A is a perspective view of an electronic device. FIG. 1B is a perspective view of a curved electronic device. FIG. 2 is a cross-sectional view of a display device.

Each of electronic devices ED and ED-1 illustrated in FIGS. 1A and 1B may include a display device DD and a housing HU that accommodates at least a portion of the display device DD. For example, a portion of a lower end of the display device DD may be accommodated in the housing HU.

Referring to FIG. 1A, the display device DD may display an image through a front surface D-U. A top surface of a member disposed at the uppermost side of the display device DD may be defined as the front surface D-U of the display device DD. According to the present disclosure, a top surface of a window WD illustrated in FIG. 2 may be defined as the front surface D-U of the display device DD.

The front surface D-U may be parallel to a plane defined by a first direction DR1 and a second direction DR2. A normal direction of the front surface D-U, that is, a thickness direction of the display device DD may be indicated by a third direction DR3. A front surface (or a top surface) and a rear surface (or a bottom surface) of each of layers or units, which will be described below, are distinguished by the third direction DR3.

The display device DD may be a transparent display device DD. The transparent display device DD may display information in a state in which an object PD disposed on a rear surface D-B of the display device DD is transparently reflected on the front side D-U of the display device DD. Thus, a user may recognize the object disposed on the rear surface D-B of the display device DD from the front surface D-U of the display device DD. The information is not limited to any one of images, content, playback screens, application execution screens, web browser screens, and various graphic objects. In FIG. 1B, a vase is shown as an example of the object PD, but the object PD is not limited thereto. The object PD may have a specific shape and is not limited to any one object.

The housing HU may protect the display device DD from an external impact or intrusion of foreign substances. The housing HU may be made of a material such as plastic or a metal. However, this is merely an example, and is not limited thereto as long as the housing HU is capable of protecting the display device DD from the external impact or the intrusion of the foreign substances. In the electronic device ED, the housing HU may be omitted, but the display device DD may be rolled to be disposed inside the housing HU through a separate hinge member.

Referring to FIG. 1B, the electronic device ED-1 may be curved along the second direction DR2 based on a virtual axis AX extending in the first direction DR1. Thus, the display device DD may be curved at a suitable curvature (e.g., a predetermined curvature), and the housing HU may have a corresponding curvature. It is not limited thereto, and the axis may extend in the second direction DR2 or be curved based on a plurality of axes extending in different directions.

In addition, the display device DD may be a rollable display panel, a foldable display panel, and/or a slidable display panel, and the entire display device DD may be disposed inside the housing HU in one operation state. Thus, the display device DD may include a curved display surface and/or a solid display surface. The solid display surface may include a plurality of display areas that indicate different directions.

Referring to FIG. 2, the display device DD may include a display panel DP, an input sensor IS, an optical layer OSL, and a window WD. The display panel DP may include a base substrate BS, a circuit element layer DP-CL disposed on the base substrate BS, a display element layer DP-OLED, and an encapsulation layer TFE. The display device DD may further include functional layers such as an anti-reflection layer, a refractive index control layer, and/or the like.

The display panel may be an emissive display panel and include one of a liquid crystal display panel, an electrophoretic display panel, a microelectromechanical system (MEMS) display panel, an electrowetting display panel, an organic light emitting display panel, an inorganic light emitting display panel, and a quantum-dot display panel, but is not particularly limited thereto.

The base substrate BS may include a synthetic resin film. The synthetic resin layer may include a thermosetting resin. Particularly, the synthetic resin layer may be a polyimide resin layer, and the material thereof is not particularly limited. The synthetic resin layer may include an acrylic-based resin, a methacrylic-based resin, a polyisoprene-based resin, a vinyl-based resin, an epoxy-based resin, a urethane-based resin, a cellulose-based resin, a siloxane-based resin, a polyamide-based resin, and/or a perylene-based resin. In addition, the base layer may include a glass substrate, a metal substrate, and/or an organic/inorganic composite substrate.

The circuit element layer DP-CL includes at least a plurality of insulating layers and a circuit element. The insulating layers described below may include an organic layer and/or an inorganic layer. The circuit element layer DP-CL forms an insulating layer, a semiconductor layer, and a conductive layer through processes such as coating and deposition. Thereafter, the insulating layer, the semiconductor layer, and the conductive layer may be selectively patterned through photolithography and etching processes. A semiconductor pattern, a conductive pattern, a signal line, and/or the like are formed through the process. The patterns disposed on the same layer are formed through the same process.

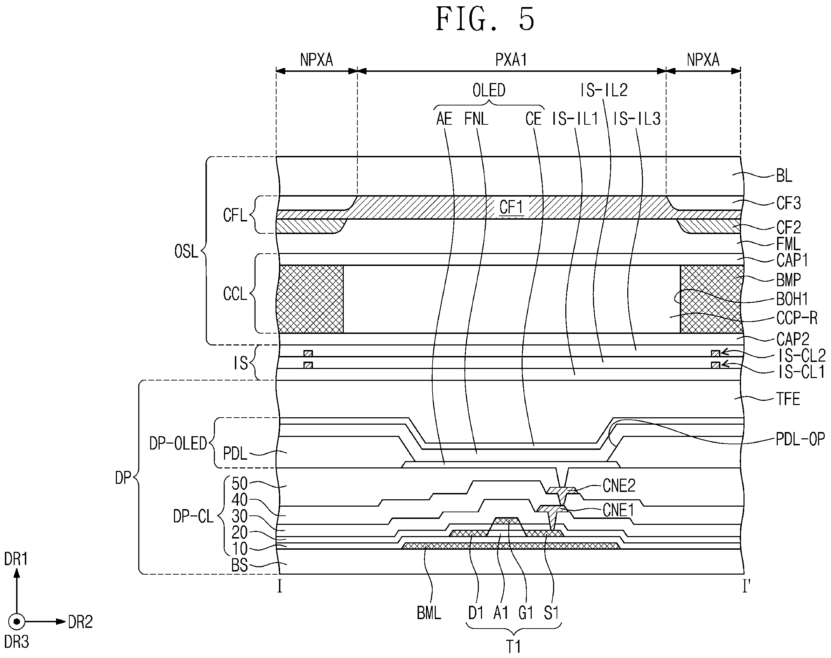

The circuit element layer DP-CL includes a driving circuit and/or signal lines, which constitutes a pixel PX. The display element layer DP-OLED may include a light emitting element OLED (see FIG. 5) and a pixel defining layer PDL (see FIG. 5), which are provided in the pixel PX.

The encapsulation layer TFE may be disposed on the display element layer DP-OLED to protect the light emitting element OLED. The encapsulation layer TFE may include inorganic layers and an organic layer disposed between the inorganic layers. The inorganic layers may protect the light emitting element OLED against moisture and oxygen, and the organic layer may protect the light emitting element OLED against foreign substances such as dust particles.

The input sensor IS may be directly disposed on the display panel DP. The input sensor IS may sense a user's input, for example, in an electromagnetic induction manner and/or a capacitance manner. The display panel DP and the input sensor IS may be formed through a continuous process. Here, "directly disposed" may mean that a third component is not disposed between the input sensor IS and the display panel DP. For example, a separate adhesive layer may not be disposed between the input sensor IS and the display panel DP.

The optical layer OSL may be disposed on the input sensor IS and may include light control patterns that are capable of changing optical properties of source light generated by the light emitting element OLED. In addition, the optical layer OSL may reduce reflectance of external light incident from an upper side of the window WD. The light control patterns may include quantum dots, and the optical layer OSL may include color filters that selectively transmit light passing through the light control patterns. The optical layer OSL may be omitted.

The window WD may be disposed on the display panel DP (e.g., may be disposed on the optical layer OSL) to transmit an image provided from the display panel DP to the outside. The window WD may include a base layer and functional layers disposed on the base layer. The functional layers may include a protective layer, an anti-fingerprint layer, and/or the like. The base layer of the window WD may be made of glass, sapphire, and/or plastic.

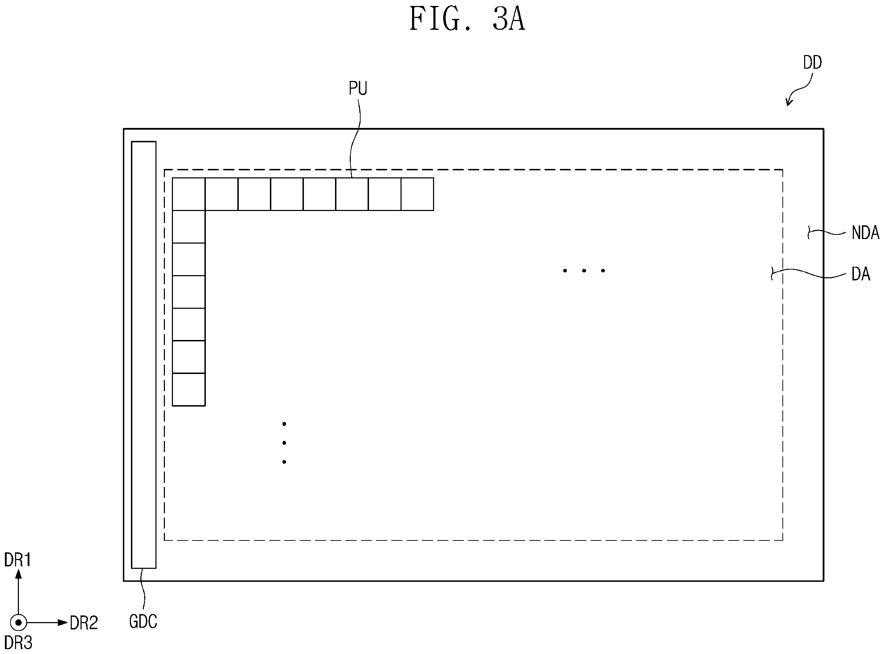

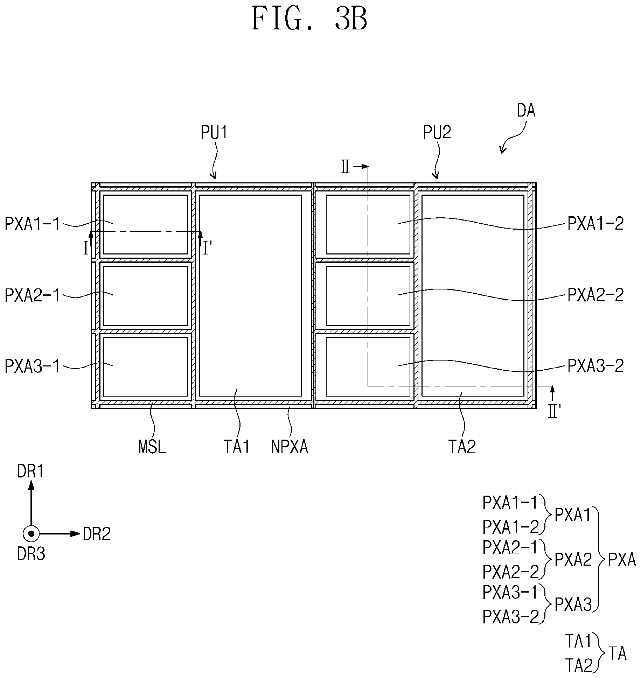

FIG. 3A is a plan view of the display device. FIG. 3B is an enlarged plan view illustrating a portion of the display device.

Referring to FIGS. 3A and 3B, the display device DD may include pixels disposed on a unit area PU, a gate driving circuit GDC connected to the pixels, and signal lines.

The display device DD may include a display area DA and a non-display area NDA around an edge or a periphery of the display area DA. An emission layer of the pixels disposed on the unit area PU may be disposed on the display area DA, and the emission layer may not be disposed on the non-display area NDA. The non-display area NDA may surround the display area DA. The non-display area NDA may be omitted or may be disposed at only one side of the display area DA. In FIG. 3A, a shape in which the display area DA and the non-display area NDA are defined on the display device DD is provided as an example, and the display area DA and the non-display area NDA may be defined to correspond to the display panel DP included in the display panel DP.

The unit area PU may be provided in plurality within the display area DA. The unit areas PU may be arranged along the first direction DR1 and the second direction DR2. The unit areas PU may include emission areas through which the display panel DP provides information to the user, a transmission area for improving transparency of the display panel DP so that an object PD disposed on the rear surface D-B of the display panel DP is transmitted to the user, and a line area on which the signal lines connected to the pixels are disposed.

FIG. 3B illustrates an example in which a first unit area PU1 and a second unit area PU2 of the unit areas PU of FIG. 3A are arranged along the second direction DR2.

The first unit area PU1 may include pixel areas PXA1-1, PXA2-1, and PXA3-1 spaced (e.g., spaced apart) from each other along the first direction DR1, and a transmission area TA1 spaced (e.g., spaced apart) from the pixel areas PXA1-1, PXA2-1, and PXA3-1 along the second direction DR2.

The second unit area PU2 may include pixel areas PXA1-2, PXA2-2, and PXA3-2 spaced (e.g., spaced apart) from each other along the first direction DR1, and a transmission area TA2 spaced (e.g., spaced apart) from the pixel areas PXA1-2, PXA2-2, and PXA3-2 along the second direction DR2.

A non-pixel area NPXA may be around (e.g., may surround) each of the pixel areas PXA and the transmission area TA adjacent to the pixel areas PXA. The display area DA may further include line areas adjacent to the pixel areas PXA and the transmission area TA. Lines such as sensing lines, power lines, and scan lines may be disposed on the line areas.

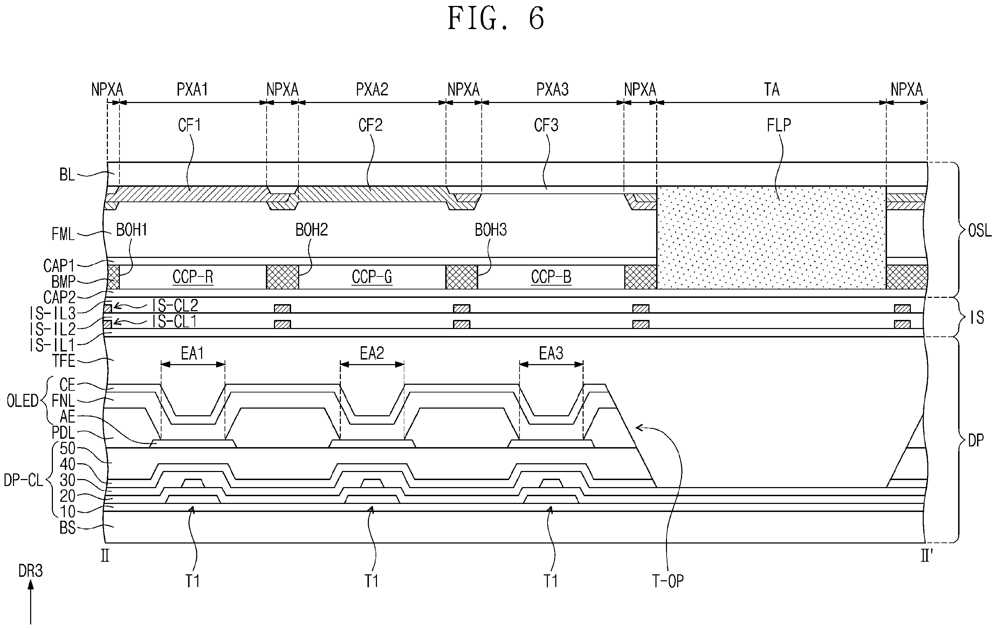

Wavelengths of the source light provided in the pixel areas PXA may be different from each other. Each of the pixel areas PXA may be defined by a light emitting opening PDL-OP included in the pixel defining layer PDL (see FIG. 5), and the transmission areas TA may be defined by a transmission opening T-OP defined in at least the pixel defining layer PDL (see FIG. 6). This will be described later.

In the display area DA of the display device, a planar area of each of the transmission areas TA may be greater than that of each of the pixel areas PXA. The planar area of each of the transmission areas TA may be greater than the sum of planar areas of the pixel areas PXA. The planar area of the transmission area TA1 included in the first unit area PU1 may be greater than the sum of the planar areas of the pixel areas PXA1-1, PXA2-1, and PXA3-1. The planar area of the transmission area TA2 included in the second unit area PU2 may be greater than the sum of the planar areas of the pixel areas PXA1-2, PXA2-2, and PXA3-2. Based on the total area of the transmission areas TA and the pixel areas PXA, the planar area of the transmission area TA may be about 60% or more. In the first unit area PU1, based on the total area of the transmission area TA1 and the pixel areas PXA1-1, PXA2-1, and PXA3-1, the planar area of the transmission area TA1 may be about 60% or more. In the second unit area PU2, based on the total area of the transmission area TA2 and the pixel areas PXA1-2, PXA2-2, and PXA3-2, the planar area of the transmission area TA2 may be about 60% or more. The display device may include the transmission area that is greater than the emission areas, so that transmittance of the display device increases and the display device may be used as a transparent display device.

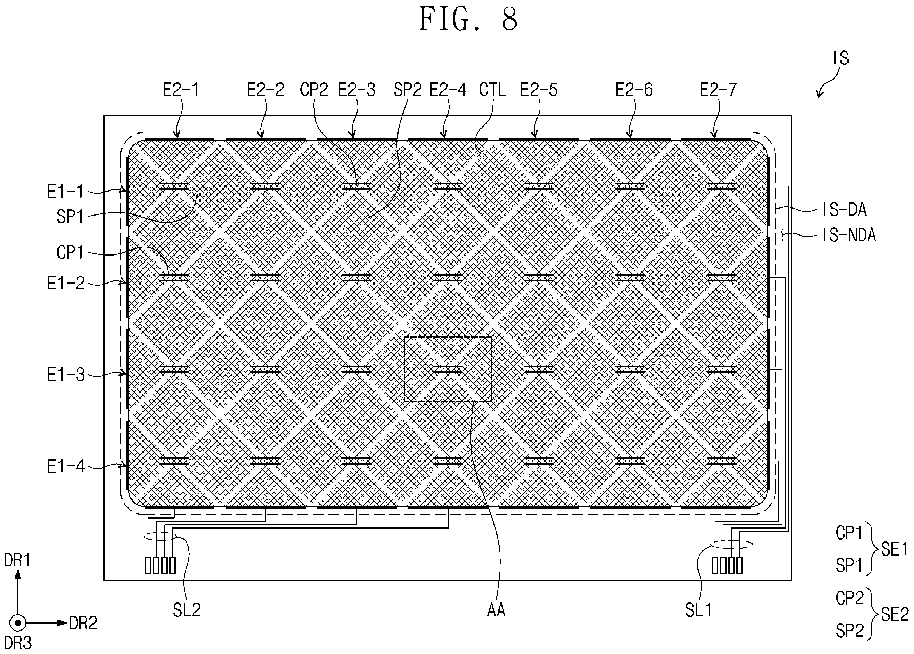

Mesh lines MSL may overlap the non-pixel area NPXA of the display area DA. The mesh lines MSL may be included in the sensing patterns SP1 and SP2 (see FIG. 8) included in sensing electrodes SE1 and SE2 (see FIG. 8) of an input sensor IS (see FIG. 8), which will be described later. The shape and arrangement of the mesh lines MSL will be described in more detail later.

Referring again to FIG. 3A, the gate driving circuit GDC may be disposed on the non-display area NDA. The gate driving circuit GDC may be integrated with the display panel DP through an oxide silicon gate driving circuit (OSG) process and/or an amorphous silicon gate driving circuit (ASG) process.

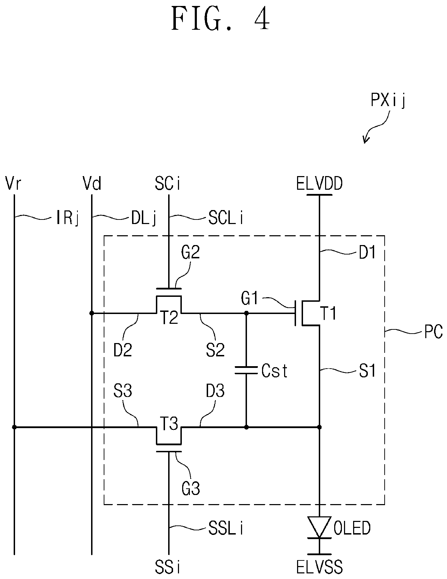

FIG. 4 is an equivalent circuit diagram of a pixel.

FIG. 4 illustrates a circuit diagram of one pixel PXij of a unit area PU (see FIG. 3A) as an example.

Referring to FIG. 4, the pixel PXij may include a pixel circuit PC and a light emitting element OLED. The pixel circuit PC may include a plurality of transistors T1 to T3 and a capacitor Cst.

The plurality of transistors T1 to T3 may be formed through a low-temperature polycrystalline silicon (LTPS) process or a low-temperature polycrystalline oxide (LTPO) process. Each of the first to third transistors T1 to T3 may include a silicon semiconductor and/or an oxide semiconductor. Here, the oxide semiconductor may include a crystalline and/or amorphous oxide semiconductor, and the silicon semiconductor may include amorphous silicon, polycrystalline silicon, and/or the like, but is not limited thereto.

Hereinafter, each of the first to third transistors T1 to T3 is described as an N-type, but is not limited thereto. For example, each of the first to third transistors T1 to T3 may be a P-type transistor and/or an N-type transistor according to an applied signal. Here, a source and drain of the P-type transistor may correspond to a drain and source of the N-type transistor, respectively.

FIG. 4 illustrates the pixel PXij connected to an i-th scan line SCLi, an i-th sensing line SSLi, a j-th data line DLj, and a j-th reference line IRj as an example.

The pixel PXij illustrated in FIG. 4 may correspond to any one of the pixels included in the unit area PU (see FIG. 3A). The pixel circuit PC may include a first transistor T1 (e.g., a driving transistor), a second transistor T2 (e.g., a switch transistor), a third transistor T3 (e.g., a sensing transistor), and a capacitor Cst. However, the pixel circuit PC may further include an additional transistor and an additional capacitor, but is not limited thereto.

Each of the first to third transistors T1 to T3 may include sources S1, S2, and S3, drains D1, D2, and D3, and gates G1, G2, and G3.

The light emitting element OLED may be an organic light emitting element or inorganic light emitting element including an anode (e.g., a first electrode) and a cathode (e.g., a second electrode). The anode of the light emitting element OLED may receive a first voltage ELVDD through the first transistor T1, and the cathode of the light emitting element OLED may receive a second voltage ELVSS. The light emitting element OLED may receive the first voltage ELVDD and the second voltage ELVSS to emit light.

The first transistor T1 may include a drain D1 receiving the first voltage ELVDD, a source S1 connected to the anode of the light emitting element OLED, and a gate G1 connected to the capacitor Cst. The first transistor T1 may control driving current flowing through the light emitting element OLED at the first voltage ELVDD in response to a voltage value stored in the capacitor Cst.

The second transistor T2 may include a drain D2 connected to the j-th data line DLj, a source S2 connected to the capacitor Cst, and a gate G2 receiving an i-th write scan signal SCi. The second transistor T2 provides a data voltage Vd to the first transistor T1 in response to the i-th first scan signal SCi.

The third transistor T3 may include a source S3 connected to the j-th reference line IRj, a drain D3 connected to the anode of the light emitting element OLED, and a gate G3 receiving the i-th sampling scan signal SSi. The j-th reference line IRj may receive a reference voltage Vr.

The capacitor Cst may store voltage differences having various values according to an input signal. For example, the capacitor Cst may store a voltage corresponding to a difference between a voltage transmitted from the second transistor T2 and the first voltage ELVDD.

In the present disclosure, an equivalent circuit of the pixel PXij is not limited to the equivalent circuit illustrated in FIG. 4. The pixel PXij may have various shapes to allow the light emitting element OLED to emit light.

FIGS. 5 and 6 are cross-sectional views of the display device DD. FIG. 5 is a cross-sectional view taken along the line I-I' of FIG. 3B. FIG. 6 is a cross-sectional view taken along the line II-II' of FIG. 3B. FIG. 5 illustrates only a portion of the configurations of the display device DD, and configurations such as the window WD (see FIG. 2) are omitted.

Referring to FIG. 5, the display device DD may include a display panel DP, an input sensor IS disposed on the display panel DP, and an optical layer OSL disposed on the input sensor IS.

The display panel DP may include a base substrate BS, a circuit element layer DP-CL disposed on the base substrate BS, a display element layer DP-OLED, and an encapsulation layer TFE.

The base substrate BS may include a synthetic resin film. The synthetic resin layer may include a thermosetting resin. Particularly, the synthetic resin layer may include an acrylic-based resin, a methacrylic-based resin, a polyisoprene-based resin, a vinyl-based resin, an epoxy-based resin, a urethane-based resin, a cellulose-based resin, a siloxane-based resin, a polyamide-based resin, and/or a perylene-based resin. In addition, the base substrate BS may include a glass substrate, a metal substrate, and/or an organic/inorganic composite substrate.

An insulating layer, a semiconductor layer, and a conductive layer may be formed through processes such as coating and deposition. Thereafter, the insulating layer, the semiconductor layer, and the conductive layer may be selectively patterned through photolithography and/or etching processes. A semiconductor pattern, a conductive pattern, a signal line, and/or the like are formed through the process. The patterns disposed on (e.g., at) the same layer are formed through the same process, and thus the circuit element layer DP-CL is formed.

The circuit element layer DP-CL may include a driving circuit or a signal line, which constitutes the pixel. The display element layer DP-OLED may include a light emitting element OLED (see FIG. 4) and a pixel defining layer PDL, which are provided in the pixel.

The circuit element layer DP-CL may include first to fifth insulating layers 10, 20, 30, 40, and 50 and conductive patterns. The first to fourth insulating layers 10 to 40 may be inorganic layers including a single layer or multiple layers, and the fifth insulating layer 50 may be an organic layer.

A light blocking pattern BML may be disposed on the base substrate BS. The light blocking pattern BML may be connected to the semiconductor pattern of the overlapping transistor T1 and receives a signal applied to the semiconductor pattern to provide a sync structure below the semiconductor pattern. The light blocking pattern BML may include sequentially laminated metal layers, where a first layer may include titanium, and a second layer may include copper.

The first insulating layer 10 may be disposed on the base substrate BS to cover the light blocking pattern BML. The first insulating layer 10 may include sequentially laminated inorganic layers, where a first layer may include silicon nitride, and a second layer may include silicon oxide.

The semiconductor pattern of the transistor T1 may be disposed on the first insulating layer 10. The semiconductor pattern may include a source region S1, a channel region A1 (or an active region), and a drain region D1. The semiconductor pattern may include indium gallium zinc oxide (IGZO).

The second insulating layer 20 may be disposed between the semiconductor pattern and the gate G1 on the first insulating layer 10 and the semiconductor pattern. The second insulating layer 20 may expose an area of the semiconductor pattern other than the active region A1. The second insulating layer 20 may be patterned using the gate G1 as a mask. The second insulating layer 20 may include silicon oxide.

The gate G1 may be disposed on the second insulating layer 20. The gate G1 may include sequentially laminated metal layers, where a first layer may include titanium, and a second layer may include copper.

The third insulating layer 30 may be disposed on the first insulating layer 10 and the second insulating layer 20 to cover the gate G1, and the semiconductor pattern exposed from the gate G1. The third insulating layer 30 may include silicon oxynitride.

A first connection electrode CNE1 may be disposed on the third insulating layer 30. The first connection electrode CNE1 may be connected to the source region S1 through a contact hole defined in the third insulating layer 30 and the second insulating layer 20. The first connection electrode CNE1 may include sequentially laminated metal layers, where a first layer may include titanium, a second layer may include copper, and a third layer may include indium tin oxide (ITO).

A fourth insulating layer 40 may be disposed on the third insulating layer 30 to cover the first connection electrode CNE1. The fourth insulating layer 40 may include silicon nitride. The layer containing silicon nitride may have a higher film density compared to the layer containing silicon oxide and/or silicon oxynitride to reduce transmittance. Thus, to increase in transmittance in a transparent display panel DP according to the present disclosure, silicon nitride may be required to be removed from the transmission area TA.

A second connection electrode CNE2 may be disposed on the fourth insulating layer 40. The second connection electrode CNE2 may be connected to the first connection electrode CNE1 through a contact hole defined in the fourth insulating layer 40. The second connection electrode CNE2 may include the same material as the first connection electrode CNE1. The display panel DP may omit the second connection electrode CNE2.

A fifth insulating layer 50 may be disposed on the fourth insulating layer 40 to cover the second connection electrode CNE2. The fifth insulating layer 50 may include an organic material. For example, the fifth insulating layer 50 may include photosensitive polyimide (PSPI).

The display element layer DP-OLED may be disposed on the fifth insulating layer 50. The display element layer DP-OLED may include a light emitting element OLED and a pixel defining layer PDL. The light emitting element OLED may include a first electrode AE, a functional layer FNL, and a second electrode CE. The functional layer FNL of the light emitting element OLED may include at least one emission layer.

A pixel defining layer PDL may be disposed on the fifth insulating layer 50 to at least partially cover the first electrode AE of the light emitting element OLED that is disposed on the fifth insulating layer 50. The pixel defining layer PDL may include an organic material. For example, the pixel defining layer PDL may include photosensitive polyimide (PSPI). The pixel defining layer PDL may include a light emitting opening PDL-OP. The light emitting opening PDL-OP of the pixel defining layer PDL may be provided in plurality, and each of the light emitting openings PDL-OP may be defined as the emission areas described in FIG. 3B. An area on which the pixel defining layer PDL is disposed may be defined as a non-emission area NLA.

The first electrode AE of the light emitting element OLED is disposed on the fifth insulating layer 50. The light emitting opening PDL-OP of the pixel defining layer PDL may expose at least a portion of the first electrode AE. The first electrode AE may include sequentially laminated conductive material layers. For example, the first electrode AE may include a three-layered conductive material layer. A first layer of the first electrode AE may include indium tin oxide (ITO), a second layer may include silver, and a third layer may include indium tin oxide (ITO).

The functional layer FNL of the light emitting element OLED may include at least one organic material layer. The functional layer FNL may include at least one emission layer. The emission layer may generate light having a specific wavelength. The emission layer may include an organic light-emitting material and/or an inorganic light-emitting material.

The functional layer FNL may further include a hole control layer and an electron control layer. At least one organic material layer included in the functional layer FNL may be commonly disposed on the emission area and the non-emission area. At least one organic material layer included in the functional layer FNL may be commonly disposed in the pixels. In the present disclosure, the layers provided as the common layers may be entirely disposed on the display area DA (see FIG. 3A) and the non-display area NDA (see FIG. 3A). The layers provided as the common layer may be defined as a "common layer."

The second electrode CE of the light emitting element OLED may be disposed on the functional layer FNL. The second electrode CE may include any suitable conductive material as those skilled in the art would appreciate.

The encapsulation layer TFE may be disposed on the display element layer DP-OLED to protect the light emitting element OLED. The encapsulation layer TEF may include inorganic layers and an organic layer disposed between the inorganic layers. The inorganic layers may protect the light emitting element OLED against moisture and/or oxygen, and the organic layer may protect the light emitting element OLED against foreign substances such as dust particles.

The inorganic layers may prevent external moisture and/or oxygen from being penetrated into the functional layer FNL of the light emitting element OLED. The inorganic layers may include silicon nitride, silicon oxide, and/or a combination thereof. The inorganic layers may be formed through a deposition process.

The organic layer may provide a planar surface on the inorganic layer. Waviness formed on the top surface of the inorganic layer or particles present on the inorganic layer may covered by the organic layer to block an influence of surface conditions of a top surface of the inorganic layer on the components disposed on the organic layer. The organic layer may include organic materials.

The input sensor IS may include a plurality of conductive patterns. The input sensor IS may include at least one conductive layer (or at least one sensor conductive layer) including the plurality of conductive patterns, and at least one insulating layer (or at least one sensor insulating layer). The input sensor IS may include a first insulating layer IS-IL1 (or first sensor insulating layer), a first conductive layer IS-CL1 (or first sensor conductive layer), a second insulating layer IS-IL2 (or second sensor insulating layer), a second conductive layer IS-CL2 (or second sensor conductive layer), and a third insulating layer IS-IL3 (or third sensor insulating layer). In FIG. 5, a plurality of conductive patterns provided in each of the first conductive layer IS-CL1 and the second conductive layer IS-CL2 are briefly illustrated.

The first insulating layer IS-IL1 may be directly disposed on the display panel DP. The first insulating layer IS-IL1 may be an inorganic layer including at least one of silicon nitride, silicon oxynitride, and/or silicon oxide. Each of the first conductive layer IS-CL1 and the second conductive layer IS-CL2 may have a single-layer structure or a multi-layered structure in which a plurality of layers are laminated in the third direction DR3. The first conductive layer IS-CL1 and the second conductive layer IS-CL2 may include conductive lines defining mesh-shaped electrodes. The conductive line of the first conductive layer IS-CL1 and the conductive line of the second conductive layer IS-CL2 may be or may not be connected to each other through a contact hole passing through the second insulating layer IS-IL2 according to their positions.

Each of the first conductive layer IS-CL1 and the second conductive layer IS-CL2, each of which has a single layer structure, may include a metal layer or a transparent conductive layer. The metal layer may include molybdenum, silver, titanium, copper, aluminum, and/or an alloy thereof. The transparent conductive layer may include transparent conductive oxide such as indium-tin oxide (ITO), indium-zinc oxide (IZO), zinc oxide (ZnOx), and/or indium zinc tin oxide (IZTO). In addition, the transparent conductive layer may include conductive polymers such as PEDOT, metal nanolines, graphene, and/or the like.

The first conductive layer IS-CL1 and the second conductive layer IS-CL2, each of which has a multi-layered structure, may include metal layers. The metal layers may have a three-layered structure of titanium/aluminum/titanium. The conductive layer having the multilayered structure may include at least one metal layer and at least one transparent conductive layer. The second insulating layer IS-IL2 may be disposed between the first conductive layer IS-CL1 and the second conductive layer IS-CL2 on the first insulating layer IS-IL1. The second insulating layer IS-IL2 disposed between the first conductive layer IS-CL1 and the second conductive layer IS-CL2 may be described as a "sensing insulating layer" in this specification. The third insulating layer IS-IL3 may cover the second conductive layer IS-CL2. The first insulating layer IS-IL1 may be omitted. Each of the second and third insulating layers IS-IL2 and IS-IL3 may include an inorganic and/or organic layer.

The optical layer OSL may convert a color of light provided from the display device. The optical layer OSL may include a light control pattern and a structure for improving light conversion efficiency.

An optical layer OSL may be disposed on the input sensor IS. The optical layer OSL may include a light control layer CCL, a color filter layer CFL, a base layer BL, a second barrier layer CAP2, and a filling layer FML. The optical layer OSL may also include a low refractive index layer. In this specification, the optical layer OSL may be referred to as an upper panel.

The light control layer CCL may be disposed on the display element layer DP-OLED including the light emitting element OLED. For example, the second barrier layer CAP2 of the optical layer OSL may be disposed on the input sensor IS and the light control layer CCL may be disposed on the second barrier layer CAP2. The light control layer CCL may include a bank BMP, a first light control pattern CCP-R, and a first barrier layer CAP1.

The bank BMP may include a base resin and an additive. In general, the base resin may include various resin compositions that are called binders. The additive may include a coupling agent and/or a photoinitiator. The additive may further include a dispersant.

The bank BMP may include a black coloring agent to block light. The bank BMP may include a black dye and/or a black pigment mixed with a base resin. The black component may include carbon black and/or may include a metal such as chromium or an oxide thereof.

The bank BMP may include a first bank opening BOH1 corresponding to the light emitting opening PDL-OP. In the plan view, a first bank opening BOH1 may overlap the light emitting opening PDL-OP and have a planar area greater than that of the light emitting opening PDL-OP. That is, the first bank opening BOH1 may have a planar area greater than that of the first emission area EA1 defined by the light emitting opening PDL-OP. In this specification, the "correspondence" means that two components overlap each other when viewed in the thickness direction DR3 of the display panel DP, but is not limited to the same area.

A first light control pattern CCP-R may be disposed inside the first bank opening BOH1. The first light control pattern CCP-R may change optical properties of the source light.

The first light control pattern CCP-R may include quantum dots that change the optical properties of the source light. The first light control pattern CCP-R may include a first quantum dot that converts the source light into light having a different wavelength. In the first light control pattern CCP-R overlapping the first pixel area PXA1, the first quantum dot may convert the source light into red light.

In this specification, the "quantum dot" refers to a crystal of a semiconductor compound. The quantum dot may emit light having various emission wavelengths depending on a size of the crystal. The quantum dot may emit light having various emission wavelengths by adjusting an element ratio in the quantum dot compound.

A diameter of the quantum dot may be, for example, about 1 nm to about 10 nm.

The quantum dots may be synthesized by a wet chemical process, an organic metal chemical vapor deposition process, a molecular beam epitaxy process, and/or a similar process.

The wet chemical process may be a method of growing quantum dot particle crystals after mixing an organic solvent and a precursor material. When the crystal is grown, the organic solvent may naturally act as a dispersant coordinated to a surface of the quantum dot crystal and may control the growth of the crystal. Therefore, the wet chemical process may be easier than vapor deposition methods such as metal organic chemical vapor deposition (MOCVD) and/or molecular beam epitaxy (MBE), and may control the growth of the quantum dot particles through a low-cost process.

A core of the quantum dot may be selected from Group II-VI compounds, Group I-II-VI compounds, Group II-IV-VI compounds, Group I-II-IV-VI compounds, Group III-V compounds, Group III-VI compounds, Group I-III-VI compounds, Group III-II-V compounds, Group II-IV-V compounds, Group IV-VI compounds, Group IV elements, Group IV components, and/or a combination thereof.

The Group II-VI compounds may be selected from binary element compounds selected from the group consisting of CdSe, CdTe, CdS, ZnS, ZnSe, ZnTe, ZnO, HgS, HgSe, HgTe, MgSe, MgS, and a combination thereof, ternary element compounds selected from the group consisting of CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and a combination thereof, and quaternary element compounds selected from the group consisting of HgZnTeS, CdZnSeS, CdZnSeTe, CdZnSTe, CdHgSeS, CdHgSeTe, CdHgSTe, HgZnSeS, HgZnSeTe, HgZnSTe, and a combination thereof. The Group II-VI semiconductor compound may further include Group I metals and/or Group IV elements. The Group I-II-VI compound may be selected from CuSnS or CuZnS, and the Group II-IV-VI compound may be selected from ZnSnS or the like. The Group I-II-IV-VI compounds may be selected from tetra-element compounds selected from the group consisting of Cu2ZnSnS2, Cu2ZnSnS4, Cu2ZnSnSe4, Ag2ZnSnS2, and mixtures thereof.

The Group III-VI compounds may include binary compounds such as In2S3 and In2Se3; ternary compounds such as InGaS3 and InGaSe3; or any combination thereof.

The Group I-III-VI compounds may be selected from ternary compounds selected from the group consisting of AgInS, AgInS2, CuInS, CuInS2, AgGaS2, CuGaS2 CuGaO2, AgGaO2, AgAlO2 and mixtures thereof or quaternary compounds such as AgInGaS2 and CuInGaS2.

The Group III-V compounds may be selected from binary element compounds selected from the group consisting of GaN, GaP, GaAs, GaSb, AIN, AIP, AlAs, AlSb, InN, InP, InAs, InSb, and a combination thereof, ternary element compounds selected from the group consisting of GaNP, GaNAs, GaNSb, GaPAs, GaPSb, AINP, AINAs, AINSb, AlPAs, AlPSb, InGaP, InAlP, InNP, InNAs, InNSb, InPAs, InPSb, and a combination thereof, and quaternary element compounds selected form the group consisting of GaAINAs, GaAINSb, GaAIPAs, GaAIPSb, GaInNP, GaInNAs, GaInNSb, GaInPAs, GaInPSb, InAINP, InAINAs, InAINSb, InAIPAs, InAIPSb, and a mixture thereof. The Group III-V compounds may further include the Group II metal. For example, InZnP or the like may be selected as the group III-II-V compounds.

The Group IV-VI compounds may be selected from binary element compounds selected from the group consisting of SnS, SnSe, SnTe, PbS, PbSe, PbTe, and a combination thereof, ternary element compounds selected from the group consisting of SnSeS, SnSeTe, SnSTe, PbSeS, PbSeTe, PbSTe, SnPbS, SnPbSe, SnPbTe, and a combination thereof, and quaternary element compounds selected form the group consisting of SnPbSSe, SnPbSeTe, SnPbSTe, and a combination thereof.

Examples of the group II-IV-V semiconductor compound may be a ternary compound selected from the group consisting of ZnSnP, ZnSnP2, ZnSnAs2, ZnGeP2, ZnGeAs2, CdSnP2, and CdGeP2, and mixtures thereof.

The Group IV elements may be selected from the group consisting of Si, Ge, and a combination thereof. The Group IV compounds may be binary element compounds selected from the group consisting of SiC, SiGe, and a combination thereof.

Each element included in the multi-element compounds, such as di-element compounds, tri-element compounds, and tetra-element compounds, may exist in the particle at a uniform or non-uniform concentration. That is, the above chemical formula may refer to types of elements included in the compound, and element ratios within the compounds may be different from each other. For example, AgInGaS2 may mean AgInxGa1-xS2 (x is a real number between 0 and 1).

Here, the binary element compounds, the ternary element compounds, and the quaternary element compounds may exist in the particle at a uniform concentration or exist in the particle in a state in which concentration distribution is partitioned into partially different states. Alternatively, the quantum dot may have a core/shell structure in which one quantum dot is around (e.g., surrounds) the other quantum dot. A core/shell structure may have a concentration gradient in which an element existing in the shell has a concentration that gradually decreases toward the core.

The quantum dot may have a core-shell structure, which includes a core including the above-described nano crystal and a shell surrounding the core. The shell of the quantum dot may serve as a protection layer that prevents or protects the core from being chemically changed to maintain the semiconductor characteristics and/or may serve as a charging layer for imparting electrophoretic characteristics to the quantum dot. The shell may be a single layer or a multi-layer. For example, the shell of the quantum dot may include oxide of a metal or nonmetal, a semiconductor compound, and/or a combination thereof.

For example, the oxide of the metal or nonmetal may include binary element compounds of SiO2, Al2O3, TiO2, ZnO, MnO, Mn2O3, Mn3O4, CuO, FeO, Fe2O3, Fe3O4, CoO, Co3O4, NiO, and/or the like or ternary element compounds MgAl2O4, CoFe2O4, NiFe2O4, CoMn2O4, and/or the like, but the present disclosure is not limited thereto.

In addition, the semiconductor compounds may include CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AIP, AlSb, and the like, but the present disclosure is not limited thereto.

The quantum dot may have a full width of half maximum (FWHM) of an emission wavelength spectrum of about 45 nm or less, or about 40 nm or less, or about 30 nm or less (e.g., about 45 nm or less, preferably about 40 nm or less, more preferably about 30 nm or less). In this range, color purity and color reproducibility may be improved. Also, light emitted through the quantum dot may be emitted in all directions to improve an optical viewing angle.

Also, the quantum dot has a shape that is generally used in the art and is not specifically limited in shape. However, the quantum dot may have a spherical shape, a pyramidal shape, a multi-arm shape, a cubic nanoparticle shape, a nanotube shape, a nanowire shape, a nanofiber shape, a nanoplate particle shape, and/or the like.

An energy band gap of the quantum dot may be adjusted by adjusting the size of the quantum dot or the element ratio in the quantum dot compound, and thus, light having various wavelengths may be obtained from a quantum dot emission layer. Thus, the quantum dots as described above (using quantum dots of different sizes or having different element ratios in the quantum dot compound) may be used to implement light emitting elements that emit light having various wavelengths. Specifically, the size of the quantum dot or the control of the element ratio in the quantum dot compound may be selected to emit red, green, and/or blue light. In addition, the quantum dots may be configured to emit white light by combining light having various colors.

The quantum dots included in the first light control pattern CCP-R overlapping the first pixel area PXA1 may have a red emission color. As a particle size of each of the quantum dots decreases, light having a short wavelength region may be emitted. For example, a particle size of each of the quantum dots emitting the green light from the quantum dots having the same core may be less than that of each of the quantum dots emitting the red light. In addition, a particle size of each of the quantum dots emitting the blue light from the quantum dots having the same core may be less than that of each of the quantum dots emitting the green light. However, the present disclosure is not limited thereto, and even in the quantum dots having the same core, the particle size may be adjusted according to the material for forming the shell and the thickness of the shell.

When the quantum dots have various light emitting colors such as the blue, red, and/or green colors, the quantum dots having different light emitting colors may have different core materials.

The first light control pattern CCP-R may further include a scatterer. The first light control pattern CCP-R may include a first quantum dot that converts blue light into red light and a scatterer that scatters light.

The scatterers may be inorganic particles. For example, the light scatterer may include at least one of TiO2, ZnO, Al2O3, SiO2, and/or hollow silica. The light scatterer may include TiO2, ZnO, Al2O3, SiO2, and/or hollow silica and/or may be a mixture of two or more materials selected from TiO2, ZnO, Al2O3, SiO2, and/or hollow silica.

The first light control pattern CCP-R may include a base resin that disperses the first quantum dot and the scatterer. The base resin may be a medium in which the first quantum dot and/or the scatterer are dispersed. In general, the base resin may include various resin compositions that are called binders. For example, the base resin may include an acrylic-based resin, a urethane-based resin, and/or a silicon-based resin, and an epoxy-based resin. The base resin may be a transparent resin.

The first light control pattern CCP-R may be formed by an inkjet process. A liquid composition may be provided within the bank opening BOH1. The composition polymerized by a thermal curing process or a light curing process may be reduced in volume after curing.

The light control layer CCL may include the first barrier layer CAP1 disposed on one surface of the first light control pattern CCP-R and the bank BMP. The first barrier layer CAP1 may serve to prevent or reduce penetration of moisture and/or oxygen (hereinafter referred to as 'moisture/oxygen') and improve optical properties of the optical layer OSL by adjusting the refractive index. The first barrier layer CAP1 may be disposed on one surface of an upper portion or one surface of a lower portion of the first light control pattern CCP-R to block the first light control pattern CCP-R from being exposed to the moisture/oxygen. In particular, the quantum dots included in the first light control pattern CCP-R may be blocked from being exposed to the moisture/oxygen. The first barrier layer CAP1 may also protect the first light control pattern CCP-R from an external impact.

The first barrier layer CAP1 may be disposed to be spaced (e.g., spaced apart) from the display element layer DP-OLED with the first light control pattern CCP-R therebetween. That is, the first barrier layer CAP1 may be disposed on a top surface of the first light control pattern CCP-R. The light control layer CCL may include a second barrier layer CAP2 disposed between the first light control pattern CCP-R and the display element layer DP-OLED. The first barrier layer CAP1 may coves the top surface of the first light control pattern CCP-R adjacent to the low refractive index layer, and the second barrier layer CAP2 may cover a bottom surface of the first light control pattern CCP-R adjacent to the display element layer DP-OLED. In this specification, the "top surface" may be a surface disposed at an upper portion based on the third direction DR3, and the "bottom surface" may be a surface disposed at a lower portion based on the third direction DR3.

In addition, the first barrier layer CAP1 and the second barrier layer CAP2 may cover one surface of the bank BMP as well as the first light control pattern CCP-R.

The first barrier layer CAP1 may cover one surface of the bank BMP and one surface of the first light control pattern CCP-R, which are adjacent to the low refractive index layer. The first barrier layer CAP1 may be disposed directly on a lower portion of the low refractive index layer. The second barrier layer CAP2 may be disposed directly on the input sensor IS disposed on an upper portion of the encapsulation layer TFE. The second barrier layer CAP2 may be disposed directly on an upper portion of the encapsulation layer TFE. The light control layer CCL may be disposed on the display element layer DP-OLED, the encapsulation layer TFE, and the input sensor IS with the second barrier layer CAP2 therebetween. The light control patterns CCP-R, CCP-G, and CCP-B (e.g., see FIG. 6) of the light control layer CCL may be formed through a continuous process on the second barrier layer CAP2 disposed on the encapsulation layer TFE and the input sensor IS.

Each of the first barrier layer CAP1 and the second barrier layer CAP2 may include an inorganic material. In the display panel DP The first barrier layer CAP1 may include silicon oxynitride (SiON). Each of both the first barrier layer CAP1 and the second barrier layer CAP2 may include silicon oxynitride. However, the present disclosure is not limited thereto, and each of the first barrier layer CAP1 and the second barrier layer CAP2 may include silicon oxide (SiOx) and/or silicon nitride (SiNx). The first barrier layer CAP1 disposed on the upper portion of the first light control pattern CCP-R may include silicon oxynitride, and the second barrier layer CAP2 disposed on the lower portion of the first light control pattern CCP-R may include silicon oxide.

A color filter layer CFL may be disposed on the light control layer CCL. The color filter layer CFL may include at least one color filter. The color filter may transmit light in a range of a specific wavelength and block light out of the range of the specific wavelength. The first color filter CF1 corresponding to the first pixel area PXA1 may transmit red light and block green light and blue light.

The first color filter CF1 may include a base resin and dye and/or pigment dispersed in the base resin. The base resin may be a medium in which the dye and/or pigment are dispersed. In general, the base resin may include various resin compositions that are called binders.

The first color filter CF1 may have a uniform thickness within the first pixel area PXA1. Light converted from the source light, which is blue light, to red light through the first light control pattern CCP-R may be provided to the outside with uniform luminance within the first pixel area PXA1.

The optical layer OSL may further include a filling layer FML disposed between the light control layer CCL and the color filter layer CFL. The filling layer FML may be filled between the light control layer CCL and the color filter layer CFL. The filling layer FML may be disposed directly on the first barrier layer CAP1, and the color filter layer CFL may be disposed directly on the filling layer FML. A bottom surface of the filling layer FML may be in contact with the top surface of the first barrier layer CAP1, and a top surface of the filling layer FML may be in contact with the bottom surfaces of the color filters (CF1, CF2, CF3) of the color filter layer CFL.

The filling layer FML may function as a buffer between the light control layer CCL and the color filter layer CFL. The filling layer FML may perform an impact absorbing function, etc., and may allow the display device DD to increase in strength. The filling layer FML may be made of a filling resin including a polymer resin. For example, the filling layer FML may be made of a filling layer resin including an acrylic resin and/or an epoxy resin.

The filling layer FML may function as an optical functional layer that is disposed between the light control layer CCL and the color filter layer CFL to improve light extraction efficiency or prevent or reduce reflected light from being incident into the light control layer CCL. The filling layer FML may be a layer having a lower refractive index than that of an adjacent layer.

The display panel DP may further include a base layer BL disposed on the color filter layer CFL. The base layer BL may be a member that provides a reference surface on which the color filter layer CFL, the low refractive index layer, and the light control layer CCL are disposed. The base layer BL may include a glass substrate, a metal substrate, a plastic substrate, and/or the like. However, the present disclosure is not limited thereto. For example, the base layer BL may be an inorganic layer, an organic layer, and/or a composite layer. In addition, unlike the illustrated configuration, the base layer BL may be omitted.

An anti-reflection layer may be disposed on the base layer BL. The anti-reflection layer may be a layer that reduces reflectance of external light incident from the outside. The anti-reflection layer may be a layer that selectively transmits light emitted from the display panel DP. The anti-reflection layer may be a single layer containing the dye and/or pigment dispersed in the base resin. The anti-reflection layer may be provided as a continuous layer that entirely overlaps the entire pixel areas PXA (see FIG. 3B).

The anti-reflection layer may not include a polarizing layer. Thus, light passing through the anti-reflection layer and incident into the display element layer DP-OLED may be non-polarized light. The display element layer DP-OLED may receive the non-polarized light from an upper portion of the anti-reflection layer.

Referring to FIG. 6, the display panel DP may include a base substrate BS and a circuit element layer DP-CL disposed on the base substrate BS. The circuit element layer DP-CL may be disposed on the base substrate BS. The circuit element layer DP-CL may include an insulating layer, a semiconductor pattern, a conductive pattern, and/or a signal line. The insulating layer, the semiconductor layer, and the conductive layer may be disposed on the base layer BS in a manner such as coating and/or deposition, and then, the insulating layer, the semiconductor layer, and the conductive layer may be selectively patterned through a plurality of photolithography processes. Thereafter, the semiconductor pattern, the conductive pattern, and the signal line included in the circuit element layer DP-CL may be provided. The circuit element layer DP-CL may include a transistor, a buffer layer, and/or a plurality of insulating layers.

The light emitting element OLED may include a first electrode AE, a second electrode CE facing the first electrode AE, and a functional layer FNL disposed between the first electrode AE and the second electrode CE. The functional layer FNL included in the light emitting element OLED may include at least a emission layer. The emission layer may include an organic light emitting material and/or quantum dots. The functional layer FNL may further include a hole control layer and an electron control layer. The light emitting element OLED may further include a capping layer disposed on the second electrode CE.

The pixel defining layer PDL may be disposed on the circuit element layer DP-CL and may cover a portion of the first electrode AE. A light emitting opening PDL-OP may be defined in the pixel defining layer PDL. The light emitting opening PDL-OP of the pixel defining layer PDL may expose at least a portion of the first electrode AE. In this implementation, emission areas EA1, EA2, and EA3 may be defined to correspond to a partial area of the first electrode AE exposed by the light emitting opening PDL-OP.

The display element layer DP-OLED may include a first emission area EA1, a second emission area EA2, and a third emission area EA3. The first emission area EA1, the second emission area EA2, and the third emission area EA3 may be areas divided by the pixel defining layer PDL. The first emission area EA1, the second emission area EA2, and the third emission area EA3 may correspond to the first pixel area PXA1, the second pixel area PXA2, and the third pixel PXA3, respectively.

The emission areas EA1, EA2, and EA3 may overlap the pixel areas PXA1, PXA2, and PXA3. When viewed on a plane, a planar area of each of the pixel areas PXA1, PXA2, and PXA3 divided by the color filters CF1, CF2, and CF3 may be greater than that of each of the emission area EA1, EA2, and EA3 divided by the pixel defining layer PDL. However, the present disclosure is not limited thereto, and the planar area of each of the pixel areas PXA1, PXA2, and PXA3 may be substantially the same as the planar area of each of the emission areas EA1, EA2, and EA3.

In the light emitting element OLED, the first electrode AE may be disposed on the circuit element layer DP-CL. The first electrode AE may be an anode or a cathode. In addition, the first electrode AE may be a pixel electrode. The second electrode CE may be a transmissive electrode, a trans-reflective electrode, and/or a reflective electrode. The transmission areas TA may be defined by a transmission opening T-OP defined in at least the pixel defining layer PDL. Further, the optical layer OSL may further include a filling pattern FLP overlapping the transmission area TA.

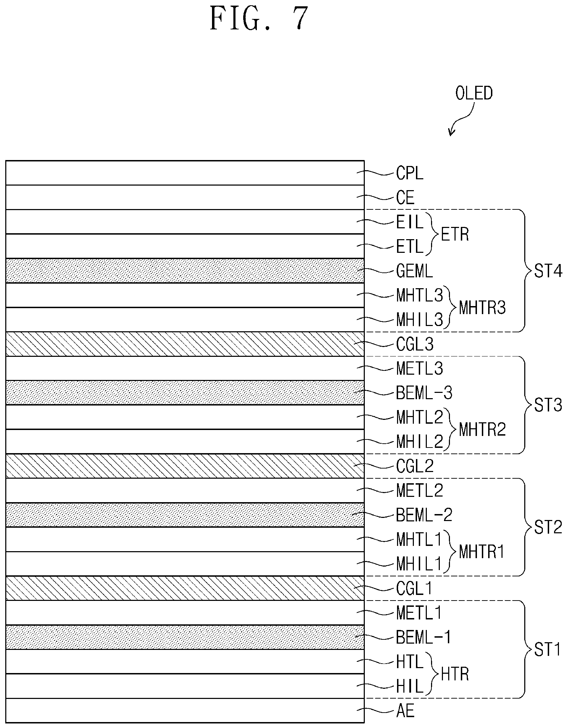

FIG. 7 is a cross-sectional view of the light emitting element. In FIG. 7, the configuration of the functional layer FNL in the light emitting element illustrated in FIGS. 5 and 6 may be embodied. FIG. 7 illustrates a light emitting element OLED including a plurality of light emitting stacks ST1, ST2, ST3, and ST4 disposed between the first electrode AE and the second electrode CE as an example.

Referring to FIG. 7, the light emitting element OLED may include a first electrode AE, a second electrode CE facing the first electrode AE, and first to fourth light emitting stacks ST1, ST2, ST3, and ST4 disposed between the first electrode AE and the second electrode CE. FIG. 7 illustrates an example in which the light emitting element OLED includes the four light emitting stacks, but the number of light emitting stacks included in the light emitting element OLED may be less or more than four.

The light emitting element OLED may include first to third charge generation layers CGL1, CGL2, and CGL3 disposed between the first to fourth light emitting stacks ST1, ST2, ST3, and ST4.

When a voltage is applied, each of the first to third charge generation layers CGL1, CGL2, and CGL3 may generate charges (e.g., electrons and holes) by forming an adhesion agent through an oxidation-reduction reaction. Thereafter, the first to third charge generation layers CGL1, CGL2, and CGL3 may provide the generated charges to the adjacent stacks ST1, ST2, ST3, and ST4, respectively. The first to third charge generation layers CGL1, CGL2, and CGL3 may doubly improve efficiency of the current generated in the adjacent stacks ST1, ST2, ST3, and ST4, and may serve to control balance of the charges between the adjacent stacks ST1, ST2, ST3, and ST4.

Each of the first to third charge generation layers CGL1, CGL2, and CGL3 may include an n-type layer and a p-type layer. The first to third charge generation layers CGL1, CGL2, and CGL3 may have a structure in which the n-type layer and the p-type layer are bonded to each other. However, the present disclosure is not limited thereto, and the first to third charge generation layers CGL1, CGL2, and CGL3 may include only one of the n-type layer and/or the p-type layer. The n-type layer may be a charge generation layer that provides electrons to the adjacent stack. The n-type layer may be a layer in which an n-dopant is doped into the base material. The p-type layer may be a charge generation layer that provides holes to the adjacent stack.

A thickness of each of the first to third charge generation layers CGL1, CGL2, and CGL3 may range of about 1 Å and about 150 Å. A concentration of the n-dopant doped in the first to third charge generation layers CGL1, CGL2, and CGL3 may be about 0.1% or more and about 3% or less, and specifically, about 1% or less. If the concentration is less than about 0.1%, an effect of the first to third charge generation layers CGL1, CGL2, and CGL3, in which the charges are balanced, may not occur. If the concentration is greater than about 3%, the light efficiency of the light emitting element OLED may be deteriorated.

Each of the first to third charge generation layers CGL1, CGL2, and CGL3 may include a charge generation compound made of an arylamine-based organic compound, a metal, metal oxide, carbide, fluoride, and/or a mixture thereof. For example, the arylamine-based organic compound may include α-NPD, 2-TNATA, TDATA, MTDATA, sprio-TAD, and/or sprio-NPB. The metal may include cesium (Cs), molybdenum (Mo), vanadium (V), titanium (Ti), tungsten (W), barium (Ba), and/or lithium (Li). Oxide, carbide, and/or fluoride of the metal may include Re₂O₇, MoOs, V₂O₅, WOs, TiOz, Cs₂CO₃, BaF, LiF, and/or CsF. However, the materials of the first to third charge generation layers CGL1, CGL2, and CGL3 are not limited to the above example.

Each of the first to fourth light emitting stacks ST1, ST2, ST3, and ST4 may include an emission layer. The first light emitting stack ST1 may include a first emission layer BEML-1, the second light emitting stack ST2 may include a second emission layer BEML-2, the third light emitting stack ST3 may include a third emission layer BEML-3, and the fourth light emitting stack ST4 may include a fourth emission layer GEML. Some of the emission layers included in the first to fourth light emitting stacks ST1, ST2, ST3, and ST4 may emit light having substantially the same color, and some may emit light having different colors.

The first to third emission layers BEML-1, BEML-2, and BEML-3 of the first to third light emitting stacks ST1, ST2, and ST3 may emit substantially the same first color light. For example, the first color light may be blue light, which is the source light described above. A wavelength range of light emitted from the first to third emission layers BEML-1, BEML-2, and BEML-3 may be about 420 nm or more and about 480 nm or less.

The fourth emission layer GEML of the fourth light emitting stack ST4 may emit second color light that is different from the first color light. For example, the second color light may be green light. A wavelength range of light emitted from the fourth emission layer GEML may be about 520 nm or more and about 600 nm or less.

The light emitting element OLED may emit light from the first electrode AE towards (e.g., in the direction of) the second electrode CE. In the light emitting element OLED, each of the plurality of stacks ST1, ST2, ST3, and ST4 may include hole transport regions HTR, MHTR1, MHTR2, and MHTR3 and electron transport regions METL1, METL2, METL3 and ETR. The hole transport regions HTR, MHTR1, MHTR2, and MHTR3 may transfer holes provided from the first electrode AE or the charge generation layer to the emission layer. The electron transport regions METL1, METL2, METL3, and ETR may transfer electrons provided from the second electrode CE or the charge generation layer to the emission layer.

The light emitting element OLED has a structure, in which the hole transport regions HTR, MHTR1, MHTR2, and MHTR3 are disposed below the light emitting layers BEML-1, BEML-2, BEML-3, and GEML included in the plurality of stacks ST1, ST2, ST3, and ST4, and the electron transport regions METL1, METL2, METL3 and ETR are disposed above the light emitting layers BEML-1, BEML-2, BEML-3, and GEML included in the plurality of stacks ST1, ST2, ST3, and ST4 based on a direction, in which the light is emitted, as an example. That is, the light emitting element OLED may have a forward element structure, but is not limited thereto. For example, the light emitting element OLED may have an inverted structure, in which the electron transport regions METL1, METL2, METL3 and ETR are disposed below the light emitting layers BEML-1, BEML-2, BEML-3, and GEML included in the plurality of stacks ST1, ST2, ST3, and ST4, and the hole transport regions HTR, MHTR1, MHTR2, and MHTR3 are disposed above the light emitting layers BEML-1, BEML-2, BEML-3, and GEML included in the plurality of stacks ST1, ST2, ST3, and ST4, based on the direction, in which the light is emitted.

The hole transport regions HTR, MHTR1, MHTR2, and MHTR3 may include hole injection layers HIL, MHIL1, MHIL2, and MHIL3 and hole transport layers HTL, MHTL1, MHTL2, MHTL3 disposed on the hole injection layers HIL, MHIL1, MHIL2, and MHIL3, respectively. The hole transport layers HTL, MHTL2, MHTL3, and MHTL3 may be in contact with the bottom surface of the emission layer. However, the present disclosure is not limited thereto, and the hole transport regions HTR, MHTR1, MHTR2, and MHTR3 may further include a hole-side additional layer disposed on the hole transport layers HTL, MHTL1, MHTL2, and MHTL3. The hole-side additional layer may include at least one of a hole buffer layer, a light emission auxiliary layer, and/or an electron blocking layer. The hole buffer layer may be a layer that compensates for a resonance distance according to a wavelength of light emitted from the emission layer to increase in light emitting efficiency. The electron blocking layer may be a layer that serves to prevent the electrons from being injected from the electron transport region to the hole transport region.

Each of the electron transport regions METL1, METL2, METL3 and ETR may include an electron transport layer. Each of the electron transport regions METL1, METL2, METL3 and ETR may further include an electron injection layer disposed on the electron transport layer. For example, the fourth electron transport region ETR included in the fourth light emitting stack ST4 may further include a fourth electron injection layer EIL disposed on the fourth electron transport layer ETL. Each of the electron transport regions METL1, METL2, METL3 and ETR may further include an additional electron layer disposed between the electron transport layer and the emission layer. The electron-side additional layer may include at least one of an electron buffer layer and/or a hole blocking layer.

In the light emitting element OLED, the first electrode AE may be a reflective electrode. For example, the first electrode AE may include Ag, Mg, Cu, Al, Pt, Pd, Au, Ni, Nd, Ir, Cr, Li, Ca, LiF/Ca, LiF/Al, Mo, Ti, W, In, Zn, Sn, and/or a compound or mixture thereof (for example, a mixture of Ag and Mg), each of which has high reflectivity. Alternatively, the first electrode AE may include the reflective layer, which is made of the above-described material, and a transparent conductive film including indium tin oxide (ITO), indium zinc oxide (IZO), zinc oxide (ZnO), and/or indium tin zinc oxide (ITZO). For example, the first electrode AE may have a two-layer structure of ITO/Ag and a three-layer structure of ITO/Ag/ITO, but is not limited thereto. For example, the first electrode AE may include the above-described metal material, a combination of two or more metal materials selected from the above-described metal materials, or oxide of the above-described metal materials. A thickness of the first electrode AE may be about 70 nm to about 1000 nm. For example, the thickness of the first electrode AE may be about 100 nm to about 300 nm.

In the light emitting element OLED, each of the hole transport regions HTR, MHTR1, MHTR2, and MHTR3 may have a single layer made of a single material, a single layer made of a plurality of different materials, or a multilayer structure having a plurality of layers made of multiple different materials.

Each of the hole transport regions HTR, MHTR1, MHTR2, and MHTR3 may be formed by using various methods such as a vacuum deposition method, a spin coating method, a casting method, a langmuir-blodgett (LB) method, an inject printing method, a laser printing method, and/or a laser induced thermal imaging (LITI) method.

Each of the hole transport regions HTR, MHTR1, MHTR2, and MHTR3 may include a phthalocyanine compound such as copper phthalocyanine, N1,N1'-([1,1'-biphenyl]-4,4'-diyl)bis(N1-phenyl-N4,N4-di-m-tolylbenzene-1,4-diamine) (DNTPD), 4,4',4"-[tris(3-methylphenyl)phenylamino] triphenylamine (m-MTDATA), 4,4'4"-Tris(N,N-diphenylamino)triphenylamine (TDATA), 2-TNATA(4,4',4"-tris[N(2-naphthyl)-N-phenylamino]-triphenylamine), poly(3,4-ethylenedioxythiophene)/poly(4-styrenesulfonate) (PEDOT/PSS), polyaniline/dodecylbenzenesulfonic acid (PANI/DBSA), polyaniline/camphor sulfonicacid (PANI/CSA), polyaniline/poly(4-styrenesulfonate) (PANI/PSS), N,N'-di(naphthalene-I-yl)-N,N'-diphenyl-benzidine (NPB), polyetherketone (TPAPEK) containing triphenylamine, 4-Isopropyl-4'-methyldiphenyliodonium [Tetrakis(pentafluorophenyl)borate], dipyrazino[2,3-f: 2',3'-h] quinoxaline-2,3,6,7,10,11-hexacarbonitrile (HATCN), and/or the like.

Each of the hole transport layers HTR, MHTR1, MHTR2, and MHTR3 may include a carbazole-based derivative such as N-phenylcarbazole and polyvinylcarbazole, a fluorene-based derivative, a triphenylamine-based derivative such as N,N'-bis(3-methylphenyl)-N,N'-diphenyl-[1,1-biphenyl]-4,4'-diamine (TPd) and 4,4',4"-tris(N-carbazolyl)triphenylamine (TCTA), N,N'-di(naphthalene-l-yl)-N,N'-diphenyl-benzidine (NPB), 4,4'-Cyclohexylidene bis[N,N-bis(4-methylphenyl)benzenamine] (TAPC), 4,4'-Bis[N,N'-(3-tolyl)amino]-3,3'-dimethylbiphenyl (HMTPD), mCP(1,3-Bis(N-carbazolyl)benzene), and/or the like.

Also, each of the hole transport regions HTR, MHTR1, MHTR2, and MHTR3 may include 9-(4-tert-Butylphenyl)-3,6-bis(triphenylsilyl)-9H-carbazole (CzSi), 9-phenyl-9H-3,9'-bicarbazole (CCP), or 1,3-bis(1,8-dimethyl-9H-carbazol-9-yl)benzene (mDCP).

The hole transport regions HTR, MHTR1, MHTR2, and MHTR3 may include the compounds of the above-described hole transport region in at least one of the hole injection layers HIL, MHIL1, MHIL2, and MHIL3, the hole transport layers HTL, MHTL1, MHTL2, and MHTL3, or the hole-side additional layer.

A thickness of each of the hole transport regions HTR, MHTR1, MHTR2, and MHTR3 may be about 10 nm to about 1,000 nm, for example, about 10 nm to about 500 nm. A thickness of each of the hole injection layers HIL, MHIL1, MHIL2, and MHIL3 may be, for example, about 5 nm to about 100 nm. Each of the hole transport layers HTL, MHTL1, MHTL2, and MHTL3 may have a thickness of about 5 nm to about 100 nm. When each of the hole transport regions HTR, MHTR1, MHTR2, and MHTR3 includes a hole-side additional layer, the thickness of the hole-side additional layer may be about 1 nm to about 100 nm. When each of the hole transport regions HTR, MHTR1, MHTR2, and MHTR3 and each layer included therein has a thickness that satisfies the above-described range, satisfactory hole transport characteristics may be obtained without a substantial increase in driving voltage.

Each of the hole transport regions HTR, MHTR1, MHTR2, and MHTR3 may further include a charge generating material so as to improve conductivity in addition to the above-described material. The charge generating material may be uniformly or non-uniformly dispersed within the hole transport regions HTR, MHTR1, MHTR2, and MHTR3. For example, the charge generating material may be a p-type dopant. The p-type dopant may include at least one of a metal halide compound, a quinone derivative, metal oxide, and/or a cyano-containing compound, but is not limited thereto. For example, the p-type dopant may include a metal halide compound such as Cul and Rbl, a quinine derivative such as tetracyanoquinodimethane (TCNQ), and 2,3,5,6-tetrafluoro-tetracyanoquinodimethane (F4-TCNQ), and/or metal oxide such as tungsten oxide and molybdenum oxide, but is not limited thereto.

Each of the blue emission layer BEML-1, BEML-2, and BEML-3 and the green emission layer GEML may include a host material and a dopant material. Each of the blue emission layer BEML-1, BEML-2, and BEML-3 and the green emission layer GEML may include a material containing a carbazole derivative moiety or an amine derivative moiety as a hole transporting host material. Each of the blue emission layer BEML-1, BEML-2, and BEML-3 and the green emission layer GEML may include a nitrogen-containing aromatic ring structure such as pyridine derivative moieties, pyridazine derivative moieties, pyrimidine derivative moieties, pyrazine derivative moieties, and/or triazine derivative moieties as an electron-transporting host material.

Each of the blue emission layer BEML-1, BEML-2, and BEML-3 and the green emission layer GEML may include anthracene derivative, pyrene derivative, fluoranthene derivative, chrysene derivative, dihydrobenzanthracene derivative, and/or triphenylene derivative as a host material. In addition, each of the blue emission layer BEML-1, BEML-2, and BEML-3 and the green emission layer GEML may further include a common material known in the art as the host material. For example, each of the blue emission layers BEML-1, BEML-2, and BEML-3 and the green emission layer GEML may include at least one of bis[2-(diphenylphosphino)phenyl] ether oxide (DPEPO), 4,4'-Bis(carbazol-9-yl)biphenyl (CBP), 1,3-Bis(carbazol-9-yl)benzene (mCP), 2,8-Bis(diphenylphosphoryl)dibenzo[b,d]furan (PPF), 4,4',4"-Tris(carbazol-9-yl)-triphenylamine (TCTA), or 1,3,5-tris(1-phenyl-1H-benzo[d]imidazole-2-yl)benzene (TPBi) as the host material. However, it is not limited thereto. For example, tris(8-hydroxyquinolino)aluminum (Alq3), poly(N-vinylcarbazole) (PVK), 9,10-di(naphthalene-2-yl)anthracene (ADN), 2-tert-butyl-9,10-di(naphth-2-yl)anthracene (TBADN), distyrylarylene (DSA), 4,4'-bis(9-carbazolyl)-2,2'-dimethyl-biphenyl (CDBP), 2-Methyl-9,10-bis(naphthalen-2-yl)anthracene (MADN), hexaphenyl cyclotriphosphazene (CP1), 1,4-Bis(triphenylsilyl)benzene (UGH2), hexaphenyl cyclotrisiloxane (DPSiOs), octaphenylcyclotetra siloxane (DPSiO₄), and/or the like may be used as the host material.

Each of the blue emission layers BEML-1, BEML-2, and BEML-3 may include styryl derivatives (for example, 1,4-bis[2-(3-N-ethylcarbazoryl)vinyl]benzene (BCzVB), 4-(di-p-tolylamino)-4'-[(di-p-tolylamino)styryl]stilbene (DPAVB), N-(4-((E)-2-(6-((E)-4-(diphenylamino)styryl)naphthalen-2-yl)vinyl)phenyl)-N-phenylbenzenamine (N-BDAVBi), 4,4'-bis[2-(4-(N,N-diphenylamino)phenyl)vinyl]biphenyl (DPAVBi)), perylene and/or its derivatives (for example, 2,5,8,11-Tetra-t-butylperylene (TBP)), pyrene, and/or their derivatives (for example, 1,1-dipyrene, 1,4-dipyrenylbenzene, 1,4-Bis(N,N-Diphenylamino) pyrene) as the known fluorescent dopant materials.

The green emission layer GEML may include a known phosphorescent dopant material. For example, a metal complex containing iridium (Ir), platinum (Pt), osmium (Os), gold (Au), titanium (Ti), zirconium (Zr), hafnium (Hf), europium (Eu), and/or terbium (Tb) and/or thulium (Tm) may be used as the phosphorescent dopant. Particularly, FIrpic(iridium(III) bis(4,6-difluorophenylpyridinato-N,C2')picolinate), Fir6(Bis(2,4-difluorophenylpyridinato)-tetrakis(1-pyrazolyl)borate iridium(III), and/or platinum octaethyl porphyrin (PtOEP) may be used as the phosphorescent dopant.

Each of the electron transport regions METL1, METL2, METL3 and ETR may have a single layer made of a single material, a single layer made of materials different from each other, or a multi-layered structure including a plurality of layers made of materials different from each other. For example, at least a portion of the electron transport regions METL1, METL2, METL3 and ETR may include an electron transport layer ETL4 and an electron injection layer EIL.

Each of the electron transport regions METL1, METL2, METL3 and ETR may be formed by using various methods such as a vacuum deposition method, a spin coating method, a casting method, a langmuir-blodgett (LB) method, an inject printing method, a laser printing method, and/or a laser induced thermal imaging (LITI) method.

The electron transport regions METL1, METL2, METL3 and ETR may include an anthracene-based compound. However, it is not limited thereto. For example, each of the electron transport regions METL1, METL2, METL3 and ETR may include, for example, tris(8-hydroxyquinolinato)aluminum (Alq3), 1,3,5-tri[(3-pyridyl)-phen-3-yl]benzene, T2T(2,4,6-tris(3'-(pyridin-3-yl)biphenyl-3-yl)-1,3,5-triazine), 2-(4-(N-phenylbenzoimidazol-1-yl)phenyl)-9,10-dinaphthylanthracene, 1,3,5-Tri(1-phenyl-1H-benzo[d]imidazol-2-yl)benzene (TPBi), 2,9-Dimethyl-4,7-diphenyl-1,10-phenanthroline (BCP), 4,7-Diphenyl-1,10-phenanthroline (Bphen), 3-(4-Biphenylyl)-4-phenyl-5-tert-butylphenyl-1,2,4-triazole (TAZ), 4-(Naphthalen-1-yl)-3,5-diphenyl-4H-1,2,4-triazole (NTAZ), 2-(4-Biphenylyl)-5-(4-tert-butylphenyl)-1,3,4-oxadiazole (tBu-PBD), Bis(2-methyl-8-quinolinolato-N1,O8)-(1,1'-Biphenyl-4-olato)aluminum (BAlq), berylliumbis(benzoquinolin-10-olate) (Bebq2), 9,10-di(naphthalene-2-yl)anthracene (ADN), 1,3-Bis [3,5-di(pyridin-3-yl)phenyl] benzene (BmPyPhB), and/or a mixture thereof.

Also, each of the electron transport regions METL1, METL2, METL3 and ETR may include a metal halide such as LiF, NaCl, CsF, RbCl, RbI, CuI, and/or KI, a lanthanum group metal such as Yb, and/or a co-deposited material of the above metal halide and the lanthanum group metal. For example, each of the electron transport regions METL1, METL2, METL3 and ETR may include KI:Yb, RbI:Yb, and/or the like as the co-deposition material. Each of the electron transport regions METL1, METL2, METL3 and ETR may include two or more materials selected from Mg, Ag, Yb, and/or Al. For example, each of the electron transport regions METL1, METL2, METL3 and ETR may include Mg and/or Yb.

As the electron transport regions METL1, METL2, METL3 and ETR, metal oxide such as LizO and BaO, or 8-hydroxyl-Lithium quinolate (Liq), and/or the like may be used, but the present disclosure is not limited thereto. Also, each of the electron transport regions METL1, METL2, METL3 and ETR may be made of a mixture of the electron transport material and organo metal salt having insulation. The organo metal salt may be a material having an energy band gap of about 4 eV or more. For example, the organo metal salt may include metal acetate, metal benzoate, metal acetoacetate, metal acetylacetonate, and/or metal stearate.

Each of the electron transport regions METL1, METL2, METL3 and ETR may further include at least one of 2,9-dimethyl-4,7-diphenyl-1,10-phenanthroline (BCP) or 4,7-diphenyl-1,10-phenanthroline (Bphen) in addition to the above-described materials, but the present disclosure is not limited thereto.

In the electron transport regions METL1, METL2, METL3 and ETR, the compounds in the electron transport region described above may be included in the electron injection layer or electron transport layer. When the electron transport regions METL1, METL2, METL3 and ETR include an electronic-side additional layer, the above-described material may be contained in the electronic-side additional layer. The electron injection layer EIL may be made of two or more materials selected from Mg, Ag, Yb, and/or Al. The electron injection layer EIL may be made of, for example, a mixture of Mg and Yb.

A thickness of each of the electron transport regions METL1, METL2, METL3 and ETR may be, for example, about 10 nm to about 150 nm. A thickness of the electron transport layer may be about 0.1 nm to about 100 nm, for example, about 0.3 nm to about 50 nm. When the electron transport layer has a thickness within the above-described range, satisfactory electron injection characteristics may be achieved without substantially increasing in driving voltage.

The second electrode CE may be provided on a plurality of light emitting stacks ST1, ST2, ST3, and ST4. The second electrode CE may be a common electrode. The second electrode CE may be a cathode or an anode, but the present disclosure is not limited thereto. For example, when the first electrode AE is the anode, the second electrode CE may be the cathode, and when the first electrode AE is the cathode, the second electrode CE may be the anode.

The second electrode CE may be a trans-reflective electrode, or a reflective electrode. When the second electrode CE is the transmissive electrode, the second electrode CE may be made of transparent metal oxide, for example, indium tin oxide (ITO), indium zinc oxide (IZO), zinc oxide (ZnO), and/or indium tin zinc oxide (ITZO).

When the second electrode CE is the trans-reflective electrode or reflective electrode, the second electrode CE may include g, Mg, Cu, Al, Pt, Pd, Au, Ni, Nd, Ir, Cr, Li, Ca, LiF/Ca, LiF/Al, Mo, Ti, Yb, W, In, Zn, Sn, and/or a compound and/or mixture (for example, AgMg, AgYb, or MgAg) thereof. Alternatively, the second electrode CE may include the reflective layer or trans-reflective layer, which is made of the above-described material, and a transparent conductive film including indium tin oxide (ITO), indium zinc oxide (IZO), zinc oxide (ZnO), and/or indium tin zinc oxide (ITZO). For example, the second electrode CE may include the above-described metal material, a combination of two or more metal materials selected from the above-described metal materials, or oxide of the above-described metal materials.

The second electrode CE may be connected to an auxiliary electrode. When the second electrode CE is connected to the auxiliary electrode, the second electrode CE may be reduced in resistance.

A capping layer CPL may be further disposed on the second electrode CE of the light emitting element OLED. The capping layer CPL may include multiple layers or a single layer.

The capping layer CPL may be an organic layer and/or an inorganic layer. For example, when the capping layer CPL may include the inorganic material, the inorganic material may include an alkali metal compound such as LiF, an alkaline earth metal compound such as MgF2, SiON, SiNX, SiOy, and/or the like.

For example, when the capping layer CPL includes the organic material, the organic material may include α-NPD, NPB, TPD, m-MTDATA, Alq3, CuPc, N4,N4,N4',N4'-tetra (biphenyl- 4-yl) biphenyl-4,4'-diamine (TPD15), 4,4',4"-Tris(carbazol sol-9-yl) triphenylamine (TCTA), and/or the like, and may include an epoxy resin, and/or acrylic such as methacrylate.

The capping layer CPL may have a refractive index of about 1.6 or more. Particularly, the capping layer CPL may have a refractive index of about 1.6 or more for light having a wavelength range of about 550 nm or more and about 660 nm or less.

Referring again to FIG. 5, in the light emitting element OLED, the functional layer FNL may be disposed between the first electrode AE and the second electrode CE. Referring to FIGS. 5 - 6, the functional layer FNL may be disposed as a common layer to entirely overlap the emission areas EA1, EA2, and EA3 and the pixel defining layer PDL that separates the emission areas EA1, EA2, and EA3 from each other. However, the present disclosure is not limited thereto, and the functional layer FNL may be patterned to be separately disposed to correspond to each of the emission areas EA1, EA2, and EA3. Alternatively, some of the plurality of organic layers included in the functional layer FNL may be patterned to be separated and disposed corresponding to each of the emission areas EA1, EA2, and EA3, and the remaining portions may be patterned to be disposed separately on the emission areas EA1, EA2, and EA3 and may be disposed as a common layer to overlap the entire pixel defining layer PDL.

The second electrode CE may be provided on the functional layer FNL. The second electrode CE may be a common electrode. The second electrode CE may be a cathode or an anode, but the present disclosure is not limited thereto. For example, when the first electrode AE is the anode, the second electrode CE may be the cathode, and when the first electrode AE is the cathode, the second electrode CE may be the anode. The second electrode CE may be a transmissive electrode, a trans-reflective electrode, or a reflective electrode.

The encapsulation layer TFE may be disposed on the light emitting element OLED. For example, the encapsulation layer TFE may be disposed on the second electrode CE. Also, when the light emitting element OLED includes the capping layer CPL, the encapsulation layer TFE may be disposed on the capping layer CPL. As described above, the encapsulation layer TFE may include at least one organic layer and at least one inorganic layer, and the inorganic layer and the organic layer may be alternately disposed.

The display panel DP may include an optical layer OSL disposed on the display element layer DP-OLED. The optical layer OSL may include, at least, a light control layer CCL, a color filter layer CFL, and a base layer BL.

The light control layer CCL may include a light converter. The light conversion material may be a quantum dot or a phosphor. The light conversion material may convert a wavelength of received light to emit light having the converted wavelength. That is, the light control layer CCL may be a layer containing quantum dots or a layer containing phosphors in in at least a portion thereof.

The light control layer CCL may include a plurality of light control patterns CCP-R, CCP-G, and CCP-B (e.g., see FIG. 6). The light control patterns CCP-R, CCP-G, and CCP-B may be spaced (e.g., spaced apart) from each other. The light control patterns CCP-R, CCP-G, and CCP-B may be disposed to be spaced (e.g., spaced apart) from each other by the bank BMP. The light control patterns CCP-R, CCP-G, and CCP-B may be disposed within the bank openings BOH1, BOH2, and BOH3 defined in the bank BMP. However, the present disclosure is not limited thereto. In FIG. 6, the bank BMP may have a rectangular shape in cross-section and is illustrated as non-overlapping the light control patterns CCP-R, CCP-G, and CCP-B, but an edge of a portion of the light control patterns CCP-R, CCP-G, and CCP-B may overlap the bank BMP. For example, the edge of the third light control pattern CCP-B may be disposed to overlap the bank BMP on a plane. The bank BMP may have a trapezoidal shape in cross-section. The bank BMP may have a shape of which a cross-sectional width increases as it approaches the display element layer DP-OLED.

The light control patterns CCP-R, CCP-G, and CCP-B may be a portion that converts a wavelength of light provided from the display element layer DP-OLED or transmits the provided light.

The light control layer CCL may include a first light control pattern CCP-R that provides red light that is the first light, a second light control pattern CCP-G that provides green light that is the second light, and a third light control pattern CCP-B that provides blue light that is the third light. The light control layer CCL may include the first light control pattern CCP-R that converts the source light provided from the light emitting element OLED into the first light, the second light control pattern CCP-G that converts the source light into second light, and the third light control pattern CCP-B that transmits source light. At least some of the light control patterns CCP-R, CCP-G, and CCP-B may include quantum dots that convert the source light into light having a specific wavelength.

At least some of the light control patterns CCP-R, CCP-G, and CCP-B may be formed by an inkjet process. Alternatively, some of the light control patterns CCP-R, CCP-G, and CCP-B may be formed by a photoresist process.

The light control layer CCL may further include a scatterer. The first light control pattern CCP-R may include a first quantum dot and a scatterer, the second light control pattern CCP-G may include a second quantum dot and a scatterer, and the third light control pattern CCP-B may not include a quantum dot and a scatterer. Each of the first light control pattern CCP-R, the second light control pattern CCP-G, and the third light control pattern CCP-B may include a base resin that disperses the quantum dots and the scatterer. The third light control pattern CCP-B may be formed through a photoresist process, as will be described later, and may include a photosensitive resin.

The light control layer CCL may include a first barrier layer CAP1 disposed on one surface of the first light control pattern CCP-R. The light control layer CCL may include the first barrier layer CAP1 spaced (e.g., spaced apart) from the display element layer DP-OLED with the first light control pattern CCP-R therebetween and the second barrier layer CAP2 adjacent to the display element layer DP-OLED.

In the display panel DP, the optical layer OSL may include a color filter layer CFL disposed on the light control layer CCL. The color filter layer CFL may include color filters CF1, CF2, and CF3. The color filter layer CFL may include a first color filter CF1 that transmits the first light, a second color filter CF2 that transmits the second light, and a third color filter CF3 that transmits the source light. The first color filter CF1 may be a red filter, the second color filter CF2 may be a green filter, and the third color filter CF3 may be a blue filter.

Each of the color filters CF1, CF2, and CF3 includes a polymer photosensitive resin and a colorant. The first color filter CF1 may include a red colorant, the second color filter CF2 may include a green colorant, and the third color filter CF3 may include a blue colorant. The first color filter CF1 may include a red pigment or red dye, the second color filter CF2 may include a green pigment or green dye, and the third color filter CF3 may include a blue pigment or blue dye.

Each of the first to third color filters CF1, CF2, and CF3 may be disposed to correspond to the first pixel area PXA1, the second pixel area PXA2, and the third pixel area PXA3, respectively (e.g., see FIG. 6). In addition, each of the first to third color filters CF1, CF2, and CF3 may be disposed to correspond to the first to third light control patterns CCP-R, CCP-G, and CCP-B, respectively (e.g., see FIG. 6).

In addition, the plurality of color filters CF1, CF2, and CF3 that transmit different light may be disposed to overlap each other and correspond to the non-pixel area NPXA disposed between the pixel areas PXA1, PXA2, and PXA3. The plurality of color filters CF1, CF2, and CF3 may be disposed to overlap each other in the third direction DR3, which is a thickness direction, so as to distinguish boundaries between the adjacent pixel areas PXA1, PXA2, and PXA3. Unlike the illustrated configuration, the color filter layer CFL may include a light blocking part that defines the boundaries between the adjacent color filters CF1, CF2, and CF3. The light blocking part may be provided as a blue filter or include an organic light blocking material and/or an inorganic light blocking material including a black pigment or dye.

The optical layer OSL may include a filling layer FML disposed between the light control layer CCL and the color filter layer CFL. The filling layer FML may be disposed between the light control patterns CCP-R, CCP-G, and CCP-B and the color filters CF1, CF2, and CF3 (e.g., see FIG. 6). The filling layer FML may be disposed above the light control layer CCL to block the light control patterns CCP-R, CCP-G, and CCP-B from being exposed to moisture/oxygen. In addition, the filling layer FML may function as an optical functional layer disposed between the light control patterns CCP-R, CCP-G, and CCP-B and the color filters CF1, CF2, and CF3 to improve light extraction efficiency or prevent the reflected light from being incident into the light control layer CCL. The filling layer FML may be a layer having a lower refractive index compared to other adjacent layers.

The optical layer OSL may further include the base layer BL disposed on the color filter layer CFL. The base layer BL may be a member that provides a base surface on which the color filter layer CFL and the light control layer CCL are disposed. The base layer BL may include a glass substrate, a metal substrate, a plastic substrate, and/or the like. However, the present disclosure is not limited thereto. For example, the base layer BL may be an inorganic layer, an organic layer, and/or a composite layer. In addition, unlike the illustrated configuration, the base layer BL may be omitted.

The optical layer OSL may further include the filling pattern FLP overlapping the transmission area TA. A portion of the optical layer OSL that overlaps the transmission area TA may not overlap the light control patterns CCP-R, CCP-G, and CCP-B, the bank BMP, the color filters CF1, CF2, and CF3, etc., and the filling pattern FLP may be disposed on the portion of the optical layer OSL. The filling pattern FLP may be disposed to overlap the transmission area TA to function as an optical functional layer that improves light extraction efficiency or prevents or reduces reflected light from being incident downward. The filling pattern FLP may be a pattern having a lower refractive index compared to other adjacent layers.

To improve transmittance of the transparent area TA in the display panel DP, at least a portion of the insulating layers disposed on the transparent area TA may be removed.

The base substrate BS, the first insulating layer 10, the second insulating layer 20, and the third insulating layer 30 may be disposed on the transmission area TA. A transmission opening T-OP overlapping the transmission area TA may be defined in the fourth insulating layer 40, the fifth insulating layer 50, the pixel defining layer PDL, and the light emitting element OLED. The transmission opening T-OP may be defined by a side surface through which a portion overlapping the transmission area TA passes with respect to each of the fourth insulating layer 40, the fifth insulating layer 50, the pixel defining layer PDL, and the light emitting element OLED. The transmission opening T-OP may be defined by removing some of the fourth insulating layer 40, the fifth insulating layer 50, the pixel defining layer PDL, and the light emitting element OLED through a dry etching process. At least a portion of the functional layer FNL included in the light emitting element OLED may be removed through an etching process. As described above, the light emitting element OLED may include the plurality of light emitting stacks ST1, ST2, ST3, and ST4, which includes the emission layer BEML-1, BEML-2, BEML-3, and GEML, and at least a portion of the plurality of light emitting stacks ST1, ST2, ST3, and ST4 may be removed from the transmission area TA corresponding to the transmission opening T-OP. Thus, at least a portion of the emission layers BEML-1, BEML-2, BEML-3, and GEML included in the plurality of light emitting stacks ST1, ST2, ST3, and ST4 may not overlap the transmission area TA.

A top surface of the third insulating layer 30 may be exposed from the fourth insulating layer 40, the fifth insulating layer 50, the pixel defining layer PDL, and the light emitting element OLED through the transmission opening T-OP. An inorganic layer included in the encapsulation layer TFE may be disposed on the top surface of the third insulating layer 30.

The description of the above-described transmission area TA may be commonly applied to the unit areas PU described in FIG. 3A. Thus, on the plane (e.g., in a plan view), a plurality of opening arranged to be spaced (e.g., spaced apart) from each other in the first direction DR1 and the second direction DR2 may be defined in the fourth insulating layer 40, the fifth insulating layer 50, the pixel defining layer PDL, and the light emitting element OLED. The openings may be arranged along the first direction DR1 and the second direction DR2 on the plane.

The fourth insulating layer 40 including silicon nitride may not be disposed on the transparent area TA of the display panel DP included in the transparent display device. Thus, the transmittance of the transmission area TA may be improved.

In FIG. 6, the transmission opening T-OP corresponding to the transmission area TA may be defined in each of the fourth insulating layer 40, the fifth insulating layer 50, the pixel defining layer PDL, and the light emitting element OLED, but is not limited thereto. For example, the transmission opening T-OP may be additionally defined in other insulating layers included in the circuit element layer DP-CL. Alternatively, the transmission opening T-OP may not be defined in some of the fourth insulating layer 40, the fifth insulating layer 50, the pixel defining layer PDL, and the light emitting element OLED. For example, some optically transparent layers of the functional layer FNL included in the light emitting element OLED may not be removed from the portion corresponding to the transmission opening T-OP.

FIG. 8 is a plan view of the input sensor IS.

As illustrated in FIG. 8, the input sensor IS may include a sensing area IS-DA and a non-sensing area IS-NDA adjacent to the sensing area IS-DA and around the sensing area IS-DA along an edge or a periphery of the sensing area IS-DA. The sensing area IS-DA and the non-sensing area IS-NDA may correspond to the display area DA and the non-display area NDA illustrated in FIG. 3A, respectively.

The input sensor IS may include the plurality of conductive patterns described above. The plurality of conductive patterns may include first electrodes SE1 (or first sensing electrodes), second electrodes SE2 (or second sensing electrodes), first signal lines SL1 (or first sensor signal lines), and second signal lines SL2 (or second sensor signal lines).

First and second sensing electrodes SE1 and SE2 that are insulated from each other and cross each other may be disposed on the sensing area IS-DA. The first signal lines SL1 connected to the first sensing electrodes SE1 and the second signal lines SL2 electrically connected to the second sensing electrodes SE2 may be disposed on the non-sensing area IS-NDA. One of the first signal lines SL1 and the second signal lines SL2 transmits a driving signal for detecting an external input from an external circuit to the corresponding electrodes, and the other outputs a sensing signal. A change in mutual capacitance between the first and second sensing electrodes SE1 and SE2 may be measured based on the sensing signal. The input sensor illustrated may refer to a "mutual cap type" input sensor.

The first sensing electrodes SE1 may be provided in a plurality of rows. The first sensing electrodes SE1 may include a first row sensing electrode E1-1, a second row sensing electrode E1-2, a third row sensing electrode E1-3, and a fourth row sensing electrode E1- 4. Unlike illustrated in FIG. 8, the first sensing electrodes SE1 may include two or three row sensing electrodes or may include five or more row sensing electrodes.

The second sensing electrodes SE2 may be provided in a plurality of columns. The second sensing electrodes SE2 may include a first column sensing electrode E2-1, a second column sensing electrode E2-2, a third column sensing electrode E2-3, and a fourth column sensing electrode E2- 4, a fifth column sensing electrode E2-5, a sixth column sensing electrode E2-6, and a seventh column sensing electrode E2-7. Unlike illustrated in FIG. 8, the second sensing electrodes SE2 may include 6 or less column sensing electrodes or may include 8 or more column sensing electrodes.

The second sensing electrodes SE2 may include second sensing patterns SP2 and connection patterns CP2. Each of the second sensing patterns SP2 may have a planar area greater than that of each of the connection patterns CP2 and may have a diamond shape. Each of the connection patterns CP2 may be disposed between the two adjacent second sensing patterns SP2. A length of each of the connection patterns CP2 may be relatively shorter than that of the second sensing patterns SP2.

Each of the first sensing electrodes SE1 may include first sensing patterns SP1 and bridge patterns CP1. Two first sensing patterns SP1, which are adjacent to each other, may be connected to two bridge patterns CP1, but the number of bridge patterns connecting the two adjacent first sensing patterns SP1 to each other is not limited.

Each of the first signal lines SL1 and the second signal lines SL2 of FIG. 8 may be provided from the first conductive layer IS-CL1 of FIG. 5. However, the present disclosure is not limited thereto, and each of the first signal lines SL1 and the second signal lines SL2 may be provided from the second conductive layer IS-CL2. Each of the first signal lines SL1 and the second signal lines SL2 may include a dual line structure including both a line provided from the first conductive layer IS-CL1 and a line provided from the second conductive layer IS-CL2.

The second sensing electrodes SE2 and the first sensing patterns SP1 may be disposed on the same layer. The bridge patterns CP1 may be disposed on a layer different from that on which the second sensing electrodes SE2 and the first sensing patterns SP1 are disposed. In the input sensor IS, the bridge patterns CP1 may be included in the first conductive layer IS-CL1 described above in FIG. 5 and may be disposed on the first insulating layer IS-IL1, and the second electrodes SE2 and the first sensing patterns SP1 may be included in the second conductive layer IS-CL2 and may be disposed on the second insulating layer IS-IL2. Alternatively, the bridge patterns CP1 may be included in the second conductive layer IS-CL2 and may be disposed on the second insulating layer IS-IL2, and the second electrodes SE2 and the first sensing patterns SP1 may be included in the first conductive layer IS-CL1 and may be disposed on the first insulating layer IS-IL1.

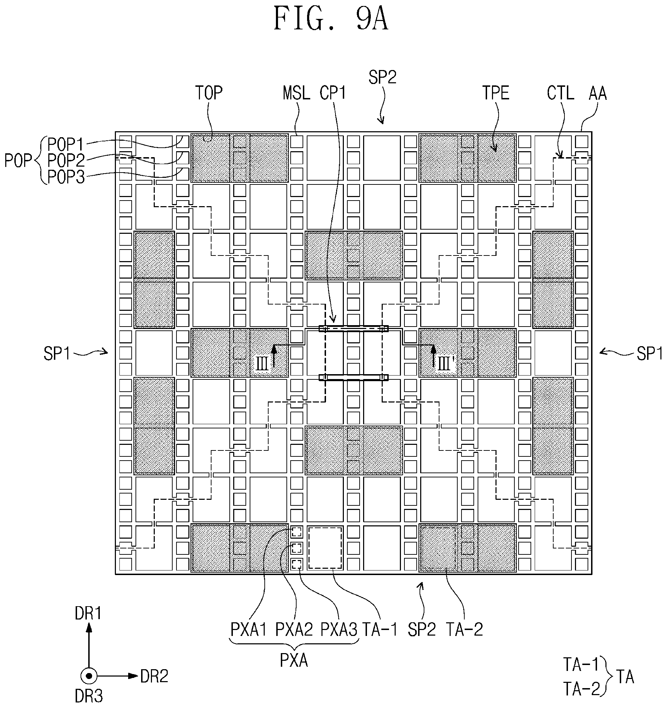

As illustrated in FIG. 8, each of the first and second sensing electrodes SE1 and SE2 may have a mesh shape in which a plurality of openings are defined. For example, the plurality of openings may overlap the corresponding emission areas and transmission areas TA of the plurality of pixel areas PXA illustrated in FIG. 3B. The second sensing electrodes SE2 may insulate and cross the first sensing electrodes SE1. The mesh shape of each of the first and second sensing electrodes SE1 and SE2 will be described later in the description of FIG. 9A and the like.

One of the first sensing electrodes SE1 and the second sensing electrodes SE2 may have an integrated shape. The second sensing electrodes SE2 having an integrated shape are illustrated as an example.

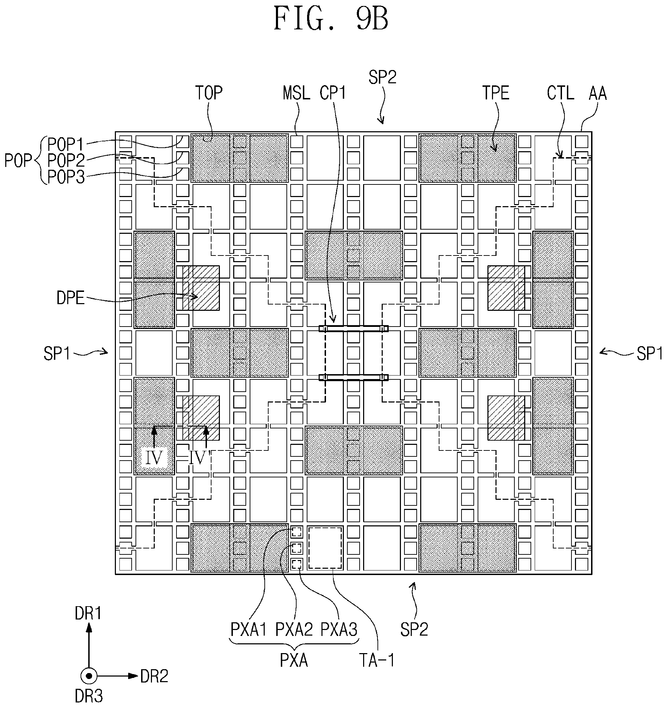

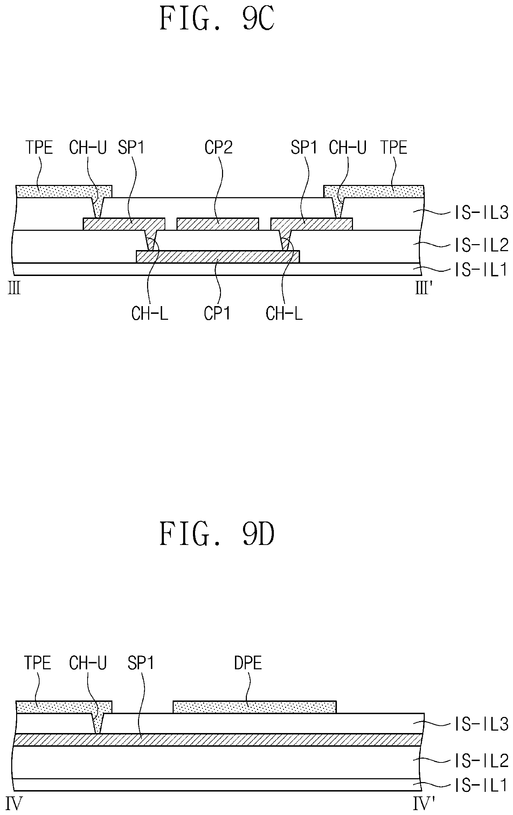

FIGS. 9A and 9B are enlarged plan views illustrating a portion of the input sensor. FIGS. 9C and 9D are enlarged cross-sectional views illustrating a portion of the input sensor. FIGS. 9A and 9B are enlarged views of an area AA illustrated in FIG. 8. FIG. 9C is a cross-sectional view taken along the line III-III' of FIG. 9A. FIG. 9D is a cross-sectional view taken along the line IV-IV' of FIG. 9B.

Referring to FIGS. 9A and 9B together, a plurality of pixel openings POP and a transmission opening TOP may be defined in each of the first and second sensing patterns SP1 and SP2.

The plurality of pixel openings POP may include a first pixel opening POP1, a second pixel opening POP2, and a third pixel opening POP3 arranged to be spaced (e.g., spaced apart) along the first direction DR1. The transmission opening TOP may be spaced (e.g., spaced apart) from each of the first pixel opening POP1, the second pixel opening POP2, and the third pixel opening POP3 along the second direction DR2.

The plurality of pixel openings POP may be openings corresponding to the above-described pixel areas PXA. The transmission opening TOP may be an opening corresponding to the transmission area TA described above. The first pixel area PXA1 may be disposed inside the first pixel opening POP1, the second pixel area PXA2 may be disposed inside the second pixel opening POP2, and the third pixel area PXA3 may be disposed inside the third pixel opening POP3.

Each of the first and second sensing patterns SP1 and SP2 may include a plurality of mesh lines MSL defining the plurality of pixel openings POP and the plurality of transmission openings TOP. The plurality of mesh lines MSL may include a plurality of mesh components extending in each of the first direction DR1 and the second direction DR2. The plurality of mesh components included in the plurality of mesh lines MSL may have the same width. However, the present disclosure is not limited thereto, and one of the mesh components included in the mesh line MSL may be thicker than the other mesh component. For example, in the mesh lines MSL, the mesh component extending in one direction may have a width greater than that of the mesh component extending in the other direction. The width of the mesh lines MSL may be, for example, about 15 micrometers or more and about 25 micrometers or less.

Each of the plurality of pixel openings POP may have a planar area larger than a planar area of the overlapping emission area. For example, a planar area of the first pixel opening POP1 may be greater than a planar area of the first pixel area PXA1, a planar area of the second pixel opening POP2 may be greater than a planar area of the second pixel area PXA2, and a planar area of the third pixel opening POP3 may be greater than a planar area of the third pixel area PXA3. As a result, the plurality of mesh lines MSL defining the plurality of pixel openings POP may not reduce emission efficiency of light emitted through the pixel areas.

The transmission opening TOP may have a planar area greater than a planar area of the overlapping transmission area TA. The planar area of the transmission opening TOP may be greater than that of the transmission area TA. As a result, the plurality of mesh lines MSL defining the transmission opening TOP may not reduce the transmittance of the display device.

The arrangement and shape of the mesh lines MSL may vary depending on the arrangement and planar area of the plurality of pixel openings POP and transmission openings TOP defined in the mesh lines MSL. In addition, the arrangement and planar area of the plurality of pixel openings POP and the transmission openings TOP may vary depending on the arrangement and area of the corresponding pixel areas PXA and transmission areas TA.

For convenience of explanation, the plurality of mesh lines MSL defining the plurality of pixel openings POP and the plurality of transmission openings TOP may be connected to each other and thus have an integrated shape. That is, the plurality of mesh lines MSL may be provided by patterning the plurality of pixel openings POP and the plurality of transmission openings TOP on the integrated conductive layer.

Referring to FIGS. 8 and 9A together, the input sensor IS includes a plurality of conductive patterns, and the plurality of conductive patterns include first sensing electrodes SE1 and second sensing electrodes SE2. The first sensing electrodes SE1 may include first sensing patterns SP1 and bridge patterns CP1. The second sensing electrodes SE2 may include second sensing patterns SP2 and connection patterns CP2. FIG. 9A is an enlarged view illustrating a planer shape of two first sensing patterns SP1 included in the first sensing electrodes SE1 and a bridge pattern CP1 connecting the first sensing patterns SP1, and two second sensing patterns SP2 included in the second sensing electrodes SE2 and the connection pattern CP2 (e.g., see FIG. 8) connecting the second sensing patterns SP2.

In the input sensor IS, a boundary part CTL may be defined between the first sensing pattern SP1 and the second sensing electrode SE2. The boundary part CTL may be a portion from which at least some of the mesh lines MSL are removed. The boundary part CTL may be provided to insulate the first sensing pattern SP1 and the second sensing electrode SE2 from each other. The boundary part CTL may be provided to insulate the first sensing pattern SP1 and the second sensing pattern SP2 from each other and to insulate the first sensing pattern SP1 and the connection pattern CP2 from each other.

Each of the second sensing patterns SP2 and the connection pattern CP2 included in the second sensing electrode SE2 may include mesh lines MSL and have an integrated shape. The connection pattern CP2 may be disposed between two adjacent second sensing patterns SP2 and may have a shape that is integrated with each of the two second sensing patterns SP2. Each of the plurality of second sensing patterns SP2 and the connection patterns CP2 illustrated in FIGS. 8 and 9A may include mesh lines MSL, and two adjacent second sensing patterns SP2 of the plurality of second sensing patterns SP2 and the connection pattern CP2 may have an integrated shape.

The bridge pattern CP1 may electrically connect two adjacent first sensing patterns SP1 to each other. The bridge pattern CP1 may overlap a lower contact hole on the plane and may electrically connect the two adjacent first sensing patterns SP1 to each other through a first contact hole.

The plurality of conductive patterns included in the input sensor IS may further include at least one transparent electrode TPE. The plurality of conductive patterns may include a plurality of transparent electrodes TPE spaced (e.g., spaced apart) from each other on the plane. The transparent electrode TPE may be provided in plurality and may be disposed throughout the sensing area IS-DA.

The transparent electrode TPE may include an optically transparent material. The transparent electrode TPE may include, for example, transparent conductive oxide (TCO). The transparent electrode TPE may include transparent conductive oxide such as indium-tin oxide (ITO), indium-zinc oxide (IZO), zinc oxide (ZnOx), and/or indium zinc tin oxide (IZTO). For example, the transparent electrode TPE may include indium tin oxide (ITO).

The transparent electrode TPE may overlap at least a portion of the first sensing electrode SE1 and the second sensing electrode SE2 on the plane. The transparent electrode TPE may overlap at least a portion of the first sensing pattern SP1, the second sensing pattern SP2, and the connection pattern CP2 on the plane. The transparent electrode TPE may be electrically connected to a portion of the first sensing pattern SP1, the second sensing pattern SP2, and the connection pattern CP2, which overlap each other on the plane.

The transparent electrode TPE may overlap at least a portion of the transmission opening TOP on the plane. The transparent electrode TPE may overlap at least a portion of the plurality of pixel openings POP on the plane. The transparent electrode TPE may overlap the transmission opening TOP and overlap at least a portion of the corresponding transmission areas TA. The transmission areas TA may include a first transmission area TA-1 that does not overlap the transparent electrode TPE on the plane and a second transmission area TA-2 that overlaps the transparent electrode TPE on the plane. The transparent electrode TPE may overlap the pixel opening POP and may overlap at least a portion of the corresponding pixel areas PXA.

Referring to FIGS. 9A and 9C, the transparent electrode TPE may be disposed on a layer different from that on which the first sensing electrode SE1 and the second sensing electrode SE2 are disposed. The transparent electrode TPE may be disposed above the first and second sensing electrodes SE1 and SE2. As illustrated in FIG. 9C, the transparent electrode TPE may be disposed on the third insulating layer IS-IL3. The transparent electrode TPE may be spaced (e.g., spaced apart) from the first sensing pattern SP1, the second sensing pattern SP2, and the connection pattern CP2 with the third insulating layer IS-IL3 therebetween. The transparent electrode TPE may be electrically connected to a corresponding portion of the first sensing pattern SP1, the second sensing pattern SP2, and the connection pattern CP2, which are disposed below the third insulating layer IS-IL3, through an upper contact hole CH-U defined in the third insulating layer IS-IL3. In the present disclosure, the third insulating layer IS-IL3 disposed between the transparent electrode TPE and the first and second sensing electrodes SE1 and SE2 may be described as a "cover insulating layer".

The input sensor IS may include a transparent electrode TPE that is electrically connected to each of the first sensing electrode SE1 and the second sensing electrode SE2 and overlaps at least a portion of the transmission area TA and the pixel area PXA to achieve high sensing sensitivity while maintaining high transmittance.

Specifically, based on the total area of the transmission area TA and the pixel areas PXA, the display device having a planar area of the transmission area TA of about 60% or more may be used as a transparent display device, but may have a low density and low sensing sensitivity in the mesh lines MSL. However, the input sensor and the display device including the same may include the transparent electrode TPE electrically connected to the mesh lines MSL of each of the first and second sensing electrodes SE1 and SE2, and thus, the conductive pattern for sensing an external input may increase in planar area and density to improve sensing sensitivity. Thus, the sensing performance of the display device including the input sensor may be improved.

Referring to FIGS. 9B and 9D, the plurality of conductive patterns included in the input sensor IS may further include at least one dummy pattern DPE. The plurality of conductive patterns may include a plurality of dummy patterns DPE spaced (e.g., spaced apart) from each other on the plane. The dummy pattern DPE may be provided in plurality and be arranged throughout the sensing area IS-DA. The dummy pattern DPE may be spaced (e.g., spaced apart) from the transparent electrodes TPE on the plane.

The dummy pattern DPE may include an optically transparent material. The dummy pattern DPE may include the same material as the transparent electrode TPE. The dummy pattern DPE may include, for example, transparent conductive oxide TCO. The dummy pattern DPE may include transparent conductive oxide such as indium-tin oxide (ITO), indium-zinc oxide (IZO), zinc oxide (ZnOx), and/or indium zinc tin oxide (IZTO). For example, the dummy pattern DPE may include indium tin oxide (ITO).

The dummy pattern DPE may overlap at least a portion of the first sensing electrode SE1 and the second sensing electrode SE2 on the plane. The dummy pattern DPE may overlap at least a portion of the first sensing pattern SP1, the second sensing pattern SP2, and the connection pattern CP2 on the plane. The dummy pattern DPE may be an isolated floating electrode that is not electrically connected to other sensing electrodes SE1 and SE2 and the transparent electrode TPE.

The dummy pattern DPE may overlap at least a portion of the transmission opening TOP on the plane. The dummy pattern DPE may overlap at least a portion of the plurality of pixel openings POP on the plane. The dummy pattern DPE may overlap the transmission opening TOP to overlap at least a portion of the corresponding transmission areas TA. The dummy pattern DPE may overlap the pixel opening POP to overlap at least a portion of the corresponding pixel areas PXA.

The dummy pattern DPE may be disposed on a layer different from that on which the first and second sensing electrodes SE1 and SE2 are disposed. The dummy pattern DPE may be disposed above the first and second sensing electrodes SE1 and SE2. The dummy pattern DPE may be disposed on (e.g., at) the same layer as the transparent electrode TPE. The dummy pattern DPE may be disposed on (e.g., at) the same layer as the transparent electrode TPE and may be formed through the same process. The dummy pattern DPE may include the same material as the transparent electrode TPE. As illustrated in FIG. 9D, the dummy pattern DPE may be disposed on the third insulating layer IS-IL3. The dummy pattern DPE may be spaced (e.g., spaced apart) from the first sensing pattern SP1, the second sensing pattern SP2, and the connection pattern CP2 with the third insulating layer IS-IL3 therebetween. The transparent electrode TPE may be electrically connected to the corresponding portions of the first sensing pattern SP1, the second sensing pattern SP2, and the connection pattern CP2, which are disposed below the third insulating layer IS-IL3, through the upper contact hole CH-U defined in the third insulating layer IS-IL3, but the dummy pattern DPE may not have a separate contact hole defined at a lower portion thereof and may be insulated from the first sensing pattern SP1, the second sensing pattern SP2, and the connection pattern CP2, which are disposed therebelow.

The input sensor may further include a dummy pattern DPE floated and spaced (e.g., spaced apart) from the transparent electrodes TPE on the plane to reduce a difference in transmittance between the portion at which the transparent electrode TPE is disposed and the portion at which the transparent electrode TPE is not disposed. Thus, visibility of the display device including the input sensor may be improved.

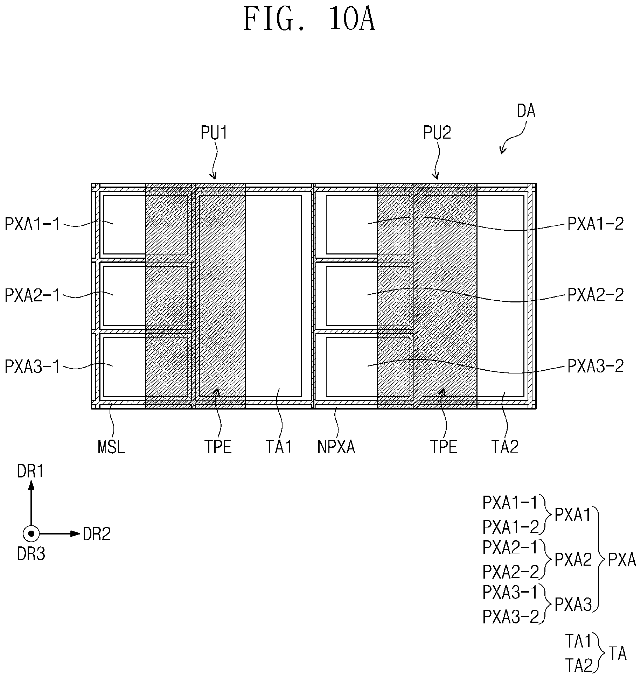

FIGS. 10A - 10C are enlarged plan views illustrating a portion of the display device. In FIGS. 10A - 10C, the overlapping relationship between the pixel areas PXA, the transmission area TA, and the transparent electrode TPE, which are described above, are illustrated in more detail.

Referring to FIG. 10A, an arrangement of the pixel areas PXA and the transmission area TA may be the same as that described above in FIG. 3B. The transparent electrode TPE may overlap a portion of the pixel areas PXA and a portion of the transmission area TA. The transparent electrode TPE may overlap a portion of the transparent area TA and may not overlap a remaining portion of the transparent area TA. The transparent electrode TPE may overlap a portion of the pixel areas PXA and may not overlap a remaining portion of the pixel area PXA.

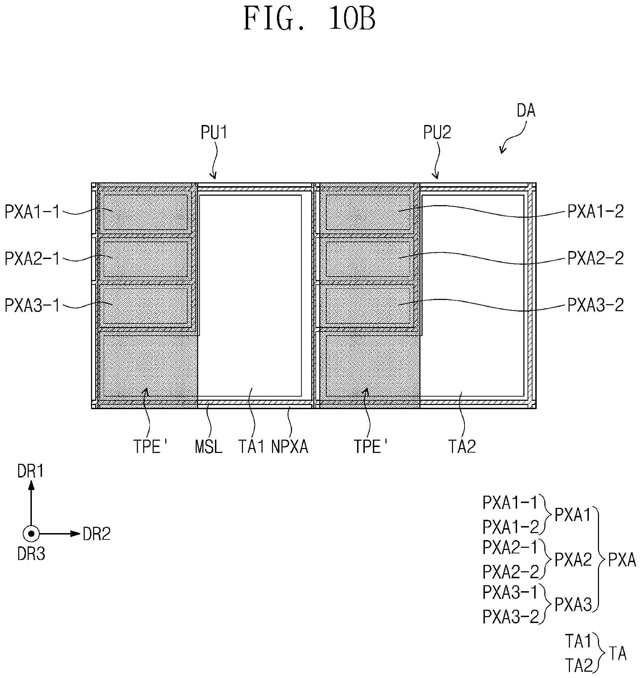

Referring to FIG. 10B, unlike illustrated in FIG. 3B, a portion of the transmission area TA may overlap the pixel areas PXA in the first direction DR1. A portion of the transmission area TA may be arranged side by side with the pixel areas PXA in the second direction DR2, and the remaining portion may extend to be arranged side by side with the pixel areas PXA in the first direction DR1.

A transparent electrode TPE' may overlap the pixel areas PXA and may overlap a portion of the transparent area TA. The transparent electrode TPE' may overlap a portion of the transparent area TA and may not overlap a remaining portion of the transparent area TA. The transparent electrode TPE' may overlap the entire pixel area PXA. The transparent electrode TPE' may overlap a portion of the transmission area TA disposed side by side in the first direction DR1 with the pixel areas PXA.

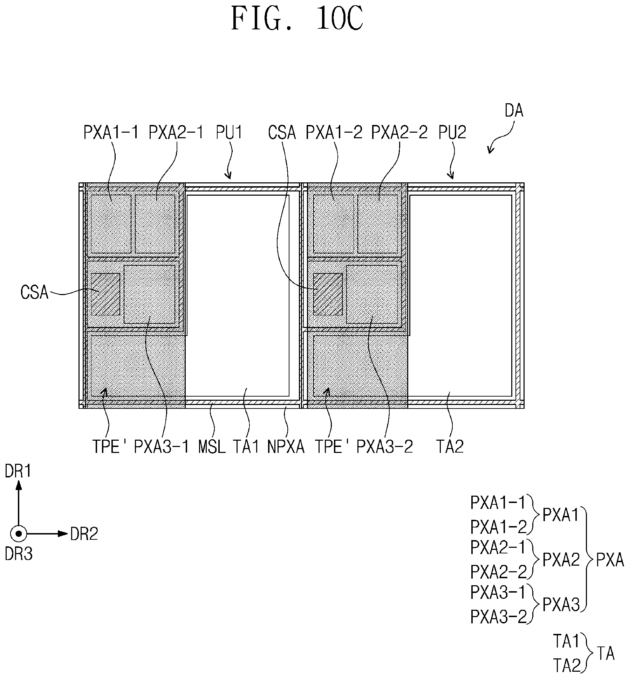

Referring to FIG. 10C, unlike illustrated in FIG. 3B, a portion of the transmission area TA may overlap the pixel areas PXA in the first direction DR1. A portion of the transmission area TA may be arranged side by side with the pixel areas PXA in the second direction DR2, and the remaining portion may extend to be arranged side by side with the pixel areas PXA in the first direction DR1.

In addition, each of the first pixel area PXA1, the second pixel area PXA2, and the third pixel area PXA3 may have an arrangement different from that illustrated in FIG. 3B. The first pixel area PXA1 and the second pixel area PXA2 may be arranged side by side in the second direction DR2, and the third pixel area PXA3 may be disposed side by side with each of the first pixel area PXA1 and the second pixel area PXA2 in the first direction DR1.

The display area DA may further include a spacer area CSA. The spacer area CSA may be an area in which a spacer is defined. The spacer may be a configuration that is included in the above-described display panel DP (see FIG. 6) so that the display panel DP (see FIG. 6) is spaced (e.g., spaced apart) from the input sensor IS (see FIG. 6) and the optical layer OSL (see FIG. 6), which are disposed thereabove. The spacer area CSA may be arranged side by side with the third pixel area PXA3 in the second direction DR2.

A transparent electrode TPE' may overlap the pixel areas PXA and may overlap a portion of the transparent area TA. The transparent electrode TPE' may overlap the spacer area CSA. The transparent electrode TPE' may overlap a portion of the transparent area TA and may not overlap a remaining portion of the transparent area TA. The transparent electrode TPE' may overlap the entire pixel area PXA and spacer area CSA. The transparent electrode TPE' may overlap a portion of the transparent area TA disposed side by side with the pixel area PXA and the spacer area CSA in the first direction DR1.

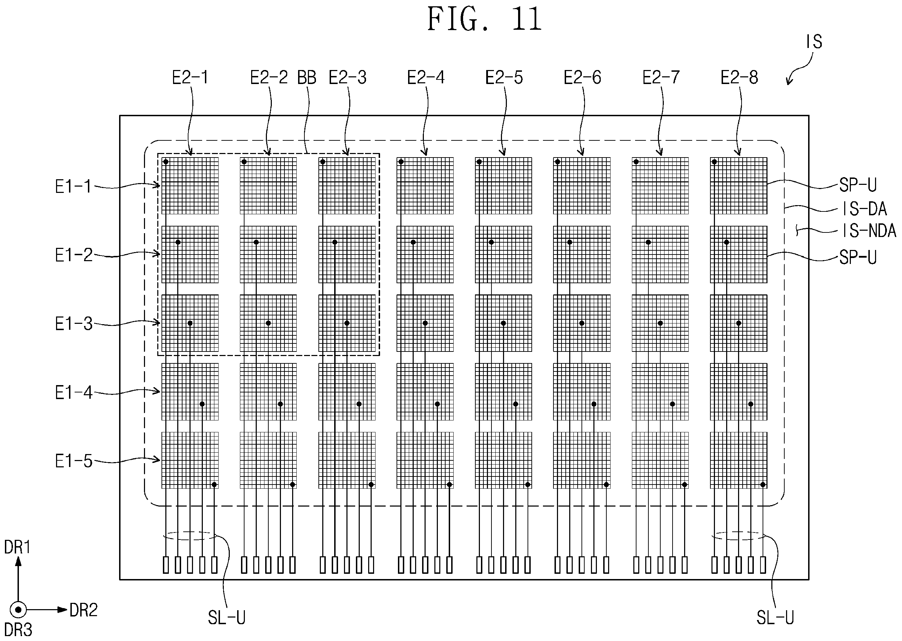

FIG. 11 is a plan view of the input sensor IS. In FIG. 11, a planar shape of the input sensor, which is different from the input sensor illustrated in FIG. 8 is illustrated.

As illustrated in FIG. 11, the input sensor IS may include a sensing area IS-DA and a non-sensing area IS-NDA adjacent to the sensing area IS-DA. The sensing area IS-DA and the non-sensing area IS-NDA may correspond to the display area DA and the non-display area NDA illustrated in FIG. 3A, respectively.

The input sensor IS may include the plurality of conductive patterns described above. The plurality of conductive patterns may include sensing patterns and signal lines. The sensing patterns may include a plurality of unit sensing patterns SP-U. The signal lines may include a plurality of unit signal lines SL-U.

A plurality of unit sensing patterns SP-U insulated from each other may be disposed on the sensing area IS-DA. Each of the plurality of unit sensing patterns SP-U may be provided in the form of a separate sensing electrode, and each of the plurality of unit sensing patterns SP-U may operate in a "self-cap method" to sense an input. The input sensor IS may sense an external input by sensing a self-capacitance voltage charged in each of the plurality of unit sensing patterns SP-U.

The plurality of unit sensing patterns SP-U may be electrically separated from each other. The plurality of unit sensing patterns SP-U may be spaced (e.g., spaced apart) from each other on the plane. FIG. 11 illustrates that each of the plurality of unit sensing patterns SP-U has a rectangular shape on the plane, but is not limited thereto, and each of the unit sensing patterns SP-U may have a polygonal, circular, oval shaped planar shape in addition to the rectangular shape.

Each of the plurality of unit sensing patterns SP-U may be connected to corresponding one of the plurality of unit signal lines SL-U. Each of the plurality of unit signal lines SL-U is connected to corresponding one of the plurality of unit sensing patterns SP-U and extends along the first direction DR1.

The plurality of unit sensing patterns SP-U may be provided in a plurality of rows. The plurality of unit sensing patterns SP-U may include a first row sensing electrode E1-1, a second row sensing electrode E1-2, a third row sensing electrode E1-3, a fourth row sensing electrode E1-4, and a fifth row sensing electrode E1-5. Unlike illustrated in FIG. 11, the first sensing electrodes SE1 may include 2 to 4 row sensing electrodes or may include 6 or more row sensing electrodes.

A plurality of unit sensing patterns SP-U may be provided in a plurality of columns. The plurality of unit sensing patterns SP-U may include a first column sensing electrode E2-1, a second column sensing electrode E2-2, a third column sensing electrode E2-3, and a fourth column sensing electrode E2- 4, a fifth column sensing electrode E2-5, a sixth column sensing electrode E2-6, a seventh column sensing electrode E2-7, and an eighth column sensing electrode E2-8. Unlike illustrated in FIG. 11, the second sensing electrodes SE2 may include 7 or less column sensing electrodes or may include 9 or more column sensing electrodes.

Each of the plurality of unit signal lines SL-U of FIG. 11 may be provided from the first conductive layer IS-CL1 of FIG. 5. However, the present disclosure is not limited thereto, and each of the plurality of unit signal lines SL-U may be provided from the second conductive layer IS-CL2. Each of the plurality of unit signal lines SL-U may have a dual line structure including both a line provided from the first conductive layer IS-CL1 and a line provided from the second conductive layer IS-CL2.

The plurality of unit sensing patterns SP-U may be disposed on (e.g., at) the same layer. In the input sensor IS, each of the plurality of unit sensing patterns SP-U may be included in the second conductive layer IS-CL2 and may be disposed on the second insulating layer IS-IL2. Each of the plurality of unit sensing patterns SP-U may be included in the first conductive layer IS-CL1 and disposed on the first insulating layer IS-IL1. Each of the plurality of unit sensing patterns SP-U may be disposed on a layer different from that on which each of the plurality of unit signal lines SL-U is disposed.

As illustrated in FIG. 11, each of the plurality of unit sensing patterns SP-U may have a mesh shape in which a plurality of opening areas are defined. For example, the plurality of opening areas may overlap the corresponding emission areas and transmission areas TA of the plurality of pixel areas PXA of FIG. 3B.

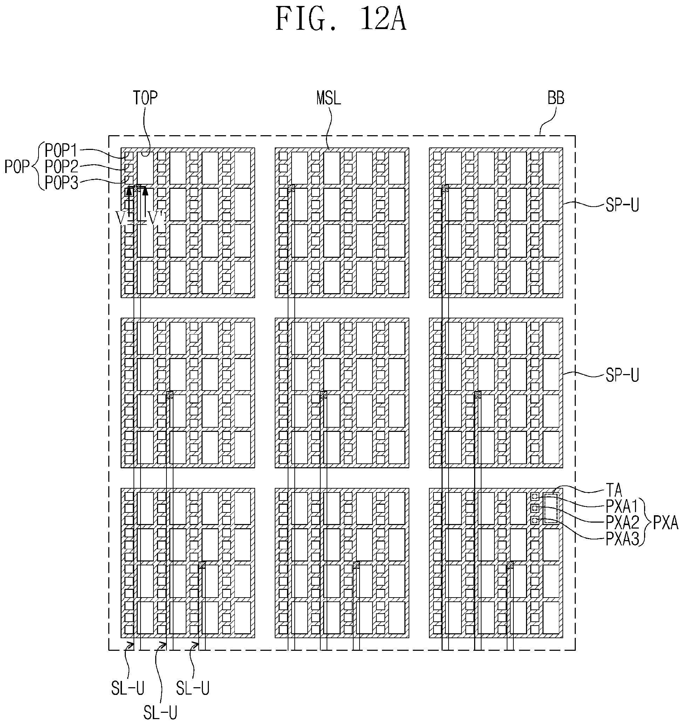

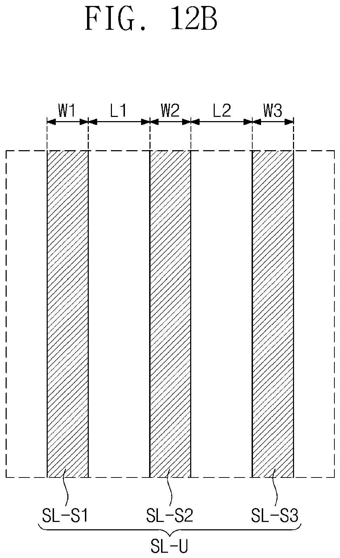

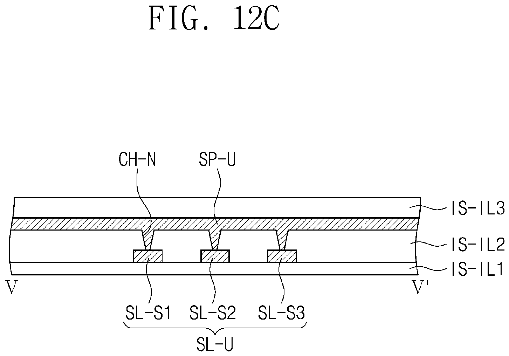

FIG. 12A is an enlarged plan view illustrating a portion of the input sensor. FIG. 12B is an enlarged plan view illustrating some of a configuration of the input sensor. FIG. 12C is an enlarged cross-sectional view illustrating a portion of the input sensor. FIG. 12A is an enlarged view illustrating a portion corresponding to an area BB illustrated in FIG. 11. FIG. 12D briefly illustrates a planar shape of the unit signal line SL-U illustrated in FIG. 12A. FIG. 12C illustrates a cross-sectional view taken along the line V-V' illustrated in FIG. 12A.

Referring to FIGS. 11 and 12A together, the input sensor IS may include a plurality of conductive patterns, and the plurality of conductive patterns may include a plurality of unit sensing patterns SP-U and a plurality of unit signal lines SL-U. FIG. 12A is an enlarged with illustrating a shape of nine unit sensing patterns SP-U of the plurality of unit sensing patterns SP-U and nine unit signal lines SL-U, which are respectively connected to the nine unit sensing patterns SP-U.

A plurality of pixel openings POP and a plurality of transmission openings TOP may be defined in each of the plurality of unit sensing patterns SP-U.

The plurality of pixel openings POP may include a first pixel opening POP1, a second pixel opening POP2, and a third pixel opening POP3 arranged to be spaced (e.g., spaced apart) along the first direction DR1. The transmission opening TOP may be spaced (e.g., spaced apart) from each of the first pixel opening POP1, the second pixel opening POP2, and the third pixel opening POP3 along the second direction DR2.

The plurality of pixel openings POP may be openings corresponding to the pixel areas PXA described in FIG. 3B. The transmission opening TOP may be an opening corresponding to the transmission area TA described in FIG. 3B. The first pixel area PXA1 may be disposed inside the first pixel opening POP1, the second pixel area PXA2 may be disposed inside the second pixel opening POP2, and the third pixel area PXA3 may be disposed inside the third pixel opening POP3.

Each of the first and second sensing patterns SP1 and SP2 may include a plurality of mesh lines MSL defining the plurality of pixel openings POP and the plurality of transmission openings TOP. The plurality of mesh lines MSL may include a plurality of mesh components extending in each of the first direction DR1 and the second direction DR2. The plurality of mesh components included in the plurality of mesh lines MSL may have the same thickness. However, the present disclosure is not limited thereto, and one of the mesh components included in the mesh line MSL may be thicker than the other mesh component. For example, in the mesh lines MSL, the mesh component extending in one direction may have a thickness greater than that of the mesh component extending in the other direction.

Each of the plurality of pixel openings POP may have a planar area larger than a planar area of the overlapping emission area. For example, a planar area of the first pixel opening POP1 may be greater than a planar area of the first pixel area PXA1, a planar area of the second pixel opening POP2 may be greater than a planar area of the second pixel area PXA2, and a planar area of the third pixel opening POP3 may be greater than a planar area of the third pixel area PXA3. As a result, the plurality of mesh lines MSL defining the plurality of pixel openings POP may not reduce emission efficiency of light emitted through the emission areas.

The transmission opening TOP may have a planar area greater than a planar area of the overlapping transmission area TA. The planar area of the transmission opening TOP may be greater than that of the transmission area TA. As a result, the plurality of mesh lines MSL defining the transmission opening TOP may not reduce the transmittance of the display device.

The arrangement and shape of the mesh lines MSL may vary depending on the arrangement and planar area of the plurality of pixel openings POP and transmission openings TOP defined in the mesh lines MSL. In addition, the arrangement and planar area of the plurality of pixel openings POP and the transmission openings TOP may vary depending on the arrangement and area of the corresponding pixel areas PXA and transmission areas TA.

For convenience of explanation, the plurality of mesh lines MSL defining the plurality of pixel openings POP and the plurality of transmission openings TOP may be connected to each other and thus have an integrated shape. That is, the plurality of mesh lines MSL may be provided by patterning the plurality of pixel openings POP and the plurality of transmission openings TOP on the integrated conductive layer.

The input sensor IS may include a plurality of conductive patterns, and the plurality of conductive patterns may include a plurality of unit sensing patterns SP-U and a plurality of unit signal lines SL-U. Each of the plurality of unit signal lines SL-U may be electrically connected to the corresponding unit sensing patterns SP-U. Each of the plurality of unit signal lines SL-U may be electrically connected to each of the mesh lines MSL of the corresponding unit sensing patterns SP-U.

FIG. 12B is an enlarged view of a planar shape of one of the plurality of unit signal lines SL-U.

Referring to FIGS. 12A and 12B, each of the unit signal lines SL-U may include a plurality of sub signal lines SL-S1, SL-S2, and SL-S3. The plurality of sub signal lines SL-S1, SL-S2, and SL-S3 may extend along the first direction DR1. The plurality of sub signal lines SL-S1, SL-S2, and SL-S3 may be spaced (e.g., spaced apart) from each other along the second direction DR2.

Each of the plurality of unit signal lines SL-U may include, for example, three sub signal lines SL-S1, SL-S2, and SL-S3. The plurality of unit signal lines SL-U may include a first sub signal line SL-S1, a second sub signal line SL-S2, and a third sub signal line SL-S3. The first sub signal line SL-S1, the second sub signal line SL-S2, and the third sub signal line SL-S3 may extend along the first direction DR1 and may be spaced (e.g., spaced apart) from each other in the second direction DR2.

A width of each of the plurality of sub signal lines SL-S1, SL-S2, and SL-S3 may be about 1 micrometer or more and about 5 micrometers. Each of a width W1 of the first sub signal line SL-S1, a width W2 of the second sub signal line SL-S2, and a width W3 of the third sub signal line SL-S3 may be about 1 micrometer or more and about 5 micrometers or less. A width of each of the plurality of sub signal lines SL-S1, SL-S2, and SL-S3 may be less than that of the mesh line MSL.

A distance between the plurality of sub signal lines SL-S1, SL-S2, and SL-S3 may be about 3 micrometers or more and about 7 micrometers or less. Each of a spaced distance L1 between the first sub signal line SL-S1 and the second sub signal line SL-S2, and a spaced distance L2 between the second sub signal line SL-S2 and the third sub signal line SL-S3 may be about 3 micrometers or more and about 7 micrometers or less.

In the input sensor IS, each of the unit signal lines SL-U electrically connected to the mesh lines MSL of the corresponding unit sensing patterns SP-U may include a plurality of sub signal lines SL-S1, SL-S2, and SL-S3 to realize excellent sensitivity while reducing or minimizing a planar area occupied by each unit signal line SL-U. Thus, the input sensor having the excellent sensitivity while reducing or minimizing a dead space and the display device including the same may be provided.

Referring to FIGS. 12A - 12C, the plurality of sub signal lines SL-S1, SL-S2, and SL-S3 included in each of the plurality of unit signal lines SL-U may have a corresponding unit sensing pattern SP-U.

Each of the plurality of unit signal lines SL-U may be disposed on a layer different from that on which the plurality of unit sensing patterns SP-U are disposed. Each of the plurality of unit signal lines SL-U may be disposed on the first insulating layer IS-IL1, and the plurality of unit sensing patterns SP-U may be disposed on the second insulating layer IS-IL2. Each of the plurality of unit signal lines SL-U may be connected to the corresponding unit sensing pattern SP-U through a unit contact hole CH-N defined in the second insulating layer IS-IL2. Each of the plurality of sub signal lines SL-S1, SL-S2, and SL-S3 may be connected to the corresponding unit sensing pattern SP-U through the unit contact hole CH-N defined in the second insulating layer IS-IL2. Each of the first sub signal line SL-S1, the second sub signal line SL-S2, and the third sub signal line SL-S3 may be connected to corresponding one unit sensing pattern SP-U through the unit contact hole CH-N defined in the second insulating layer IS-IL2.

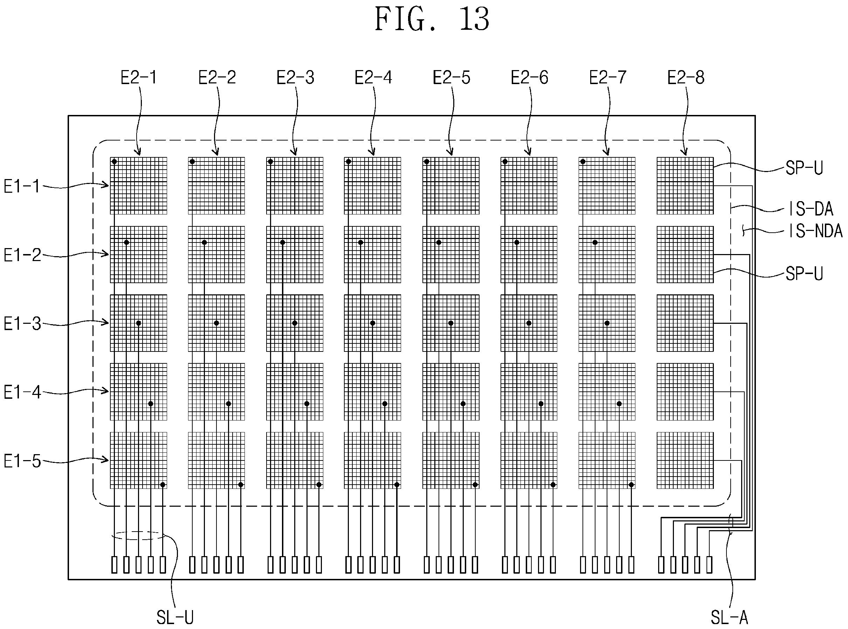

FIG. 13 is a plan view of the input sensor IS. FIG. 13 illustrates a planar shape of an input sensor different from the input sensor illustrated in FIG. 11.

Referring to FIG. 13, unlike the input sensor illustrated in FIG. 11, an input sensor may further include an additional signal line SL-A.

The additional signal line SL-A may have a shape integral with a portion of the plurality of unit sensing patterns SP-U. The additional signal line SL-A may be electrically connected to a portion of the plurality of unit sensing patterns SP-U. In FIG. 13, an example, in which an eighth column sensing electrode E2-8 has an integral shape with an additional signal line SL-A and the eighth column sensing electrode E2-8 is electrically connected to the additional signal line SL-A, is illustrated, but is not limited thereto. For example, the additional signal line SL-A may have an integral shape with a portion of the plurality of unit sensing patterns SP-U provided in a plurality of rows and columns and may be electrically connected to the unit sensing pattern SP-U.

The additional signal line SL-A may be disposed on (e.g., at) the same layer as the plurality of unit sensing patterns SP-U. In the input sensor IS, the plurality of unit sensing patterns SP-U and the additional signal line SL-A may be included in the second conductive layer IS-CL2 and may be disposed on the second insulating layer IS-IL2. Alternatively, the plurality of unit sensing patterns SP-U and the additional signal line SL-A may be included in the first conductive layer IS-CL1 and disposed on the first insulating layer IS-IL1. The additional signal line SL-A may be disposed on a layer different from that on which each of the plurality of unit signal lines SL-U is disposed.

In FIG. 13, an example, in which the unit signal lines SL-U are not connected in the case of the eighth heat sensing electrodes E2-8 connected to the additional signal line SL-A, but is not limited thereto. For example, the unit signal lines SL-U may also be connected to the eighth column sensing electrodes E2-8 to which the additional signal line SL-A is connected, respectively.

Hereinafter, characteristics of an input sensor according to one or more embodiments and an input sensor according to a comparative example are compared and shown in Table 1 below. In Table 1 below, Embodiment 1 had a mutual cap type input sensor structure illustrated in FIG. 8 and had sensitivity of the input sensor including transparent electrodes as illustrated in FIG. 9A. Embodiment 2 showed sensitivity of an input sensor which has the self-cap input sensor structure illustrated in FIG. 11 and in which, as illustrated in FIGS. 12A - 12C, the unit signal lines are connected to the unit sensing patterns, respectively, and each of the unit signal lines includes three sub-signal lines. Comparative example 1 showed sensitivity of an input sensor having the mutual cap type input sensor structure shown in FIG. 8, but not including the transparent electrode illustrated in FIG. 9A.

**[Table 1]**

| | Embodiment 1 | Embodiment 2 | Comparative Example 1 |
|---|---|---|---|
| Mesh line width (µm) | 18.9 | 18.9 | 18.9 |
| Capacitance change (fF) | 40 | 415 | 17 |

Referring to the results in Table 1, it is seen that, although the input sensors according to the embodiments had the same mesh line width as a comparative example 1, the capacitance change value significantly increases compared to the capacitance change value according to the comparative example. As a result, it is confirmed that the input sensors according to the embodiments are applied to the transparent display device in which the planar area of the transparent area is about 60% or more based on the total area of the transparent area and pixel areas and which has excellent sensitivity.

According to the embodiments of the present disclosure, the ratio of the transmission area on the display area may increase to improve the transmittance of the display device, and the range of change in capacitance of the input sensor may be secured significantly to improve the sensing performance of the input sensor and the display device including the input sensor.
It will be apparent to those skilled in the art that various modifications and variations can be made in the present disclosure. Thus, it is intended that the present disclosure covers the modifications and variations of embodiments provided that they come within the scope of the appended claims.

## Claims

1. A display device comprising:
a display panel comprising a display area (DA) including a transmission area (TA), and a non-display area (NDA) adjacent to the display area; and
an input sensor (IS) on the display panel and comprising a plurality of conductive patterns,
wherein the plurality of conductive patterns comprise:
a first sensing electrode (SE1) comprising a plurality of first sensing patterns (SP1) arranged along a first direction and a plurality of bridge patterns (CP1) configured to connect two adjacent first sensing patterns of the plurality of first sensing patterns to each other;
a second sensing electrode (SE2) spaced from the first sensing electrode and comprising a plurality of second sensing patterns (SP2) arranged along a second direction crossing the first direction; and
a transparent electrode (TPE) electrically connected to at least a portion of the first sensing electrode (SE1) and the second sensing electrode (SE2),
wherein each of the plurality of first sensing patterns and the plurality of second sensing patterns comprises a plurality of mesh lines in which a transmission opening (T-OP) overlapping the transmission area (TA) is located, and
wherein the transparent electrode (TPE) overlaps at least a portion of the transmission area (TA).

2. The display device of claim 1, wherein the display area further comprises a plurality of pixel areas adjacent to the transmission area and configured to emit light.

3. The display device of claim 2, wherein, in the display area, a ratio of the transmission area to a total area of the transmission area and the plurality of pixel areas is about 60% or more.

4. The display device of any one of the preceding claims, wherein the input sensor further comprises a cover insulating layer between the first and second sensing electrodes and the transmission electrode, and
wherein the transparent electrode is electrically connected to at least a portion of the first sensing electrode and the second sensing electrode through an upper contact hole that passes through the cover insulating layer.

5. The display device of claim 2, wherein the transparent electrode overlaps at least a portion of each of the transmission area and the plurality of pixel areas.

6. The display device of any one of the preceding claims, wherein the plurality of conductive patterns further comprise a dummy pattern at the same layer as the transparent electrode and insulated from the first sensing electrode and the second sensing electrode.

7. The display device of claim 2, wherein the plurality of pixel areas comprise a first pixel area, a second pixel area, and a third pixel area, and
wherein the transmission area is adjacent to each of the first pixel area, the second pixel area, and the third pixel area along the first direction.

8. The display device of any one of the preceding claims, wherein the transparent electrode comprises transparent conductive oxide (TCO).

9. The display device of claim 2, wherein the display panel comprises a light emitting element configured to emit source light and overlapping a corresponding one of at least the plurality of pixel areas, and
the light emitting element comprises:
a first electrode;
a first light emitting stack on the first electrode;
a second light emitting stack on the first light emitting stack;
a third light emitting stack on the second light emitting stack;
a fourth light emitting stack on the third light emitting stack;
a second electrode on the fourth light emitting stack; and
charge generation layers between the first, second, third, and fourth light emitting stacks, respectively,
wherein each of the first to fourth light emitting stacks comprises at least one emission layer.

10. The display device of claim 9, further comprising a light control layer on the light emitting element to transmit the source light or convert the source light into light having a different wavelength from that of the source light.

11. The display device of claim 10, wherein the light control layer comprises:
a bank including a plurality of bank openings; and
a plurality of light control patterns in the plurality of bank openings, respectively,
wherein the plurality of light control patterns do not overlap the transmission area.

12. The display device of claim 9, 10 or 11, wherein the at least one emission layer in each of the first light emitting stack to the fourth light emitting stack does not overlap the transmission area.

13. The display device of any one of the preceding claims, wherein the second sensing electrode further comprises a connection pattern between adjacent two second sensing patterns of the plurality of second sensing patterns and having a shape integrated with the plurality of second sensing patterns.

14. The display device of any one of the preceding claims, wherein the input sensor further comprises a sensing insulating layer between the plurality of bridge patterns and the plurality of first sensing patterns,
wherein each of the plurality of bridge patterns is electrically connected to corresponding one of the plurality of first sensing patterns through a lower contact hole defined in the sensing insulating layer.

15. The display device of any one of the preceding claims, wherein the transmission area comprises:
a first transmission area overlapping the transparent electrode on a plane; and
a second transmission area that does not overlap the transparent electrode on the plane.
